# EUROPEAN PATENT SPECIFICATION

(11) **EP 2 412 674 B1**
(45) Date of publication and mention of the grant of the patent: **07.11.2018**
(21) Application number: 10756075.7
(22) Date of filing: 23.03.2010
(51) Int. Cl.: C01G 19/00, C01B 13/14, H01B 5/14, H01L 51/54, H05B 33/28

(54) **ELECTRODE AND ORGANIC ELECTROLUMINESCENT ELEMENT**
ELEKTRODE UND ORGANISCHES ELEKTROLUMINESZENZELEMENT
ÉLECTRODE ET ÉLÉMENT ÉLECTROLUMINESCENT ORGANIQUE

(30) Priority: 26.03.2009 JP 2009077626
(43) Date of publication of application: 01.02.2012
(73) Proprietor: UDC Ireland Limited, Ballycoolin, Dublin 15 (IE)
(72) Inventor: Kato,Takashi, Kanagawa (JP); Hayashi,Naoyuki, Kanagawa (JP)
(74) Representative: Maiwald Patent- und Rechtsanwaltsgesellschaft mbH
(86) International application number: PCT/JP2010/055011
(87) International publication number: WO 2010/110279

(56) References cited:
- WO-A1-2008/060534
- WO-A1-2010/007081
- JP-A- 2004 047 176
- JP-A- 2005 085 731
- US-A1- 2003 087 127
- US-A1- 2003 162 053
- US-A1- 2005 280 604
- JAEMIN LEE ET AL: "Modification of an ITO anode with a hole-transporting SAM for improved OLED device characteristics", JOURNAL OF MATERIALS CHEMISTRY, THE ROYAL SOCIETY OF CHEMISTRY, CAMBRIDGE, GB, vol. 12, no. 12, 4 October 2002 (2002-10-04), pages 3494-3498, XP002507277, ISSN: 0959-9428, DOI: 10.1039/B206939C [retrieved on 2002-10-04]
- MITSUHIKO MORISUE ET AL: "Efficient Charge Injection from the S2 Photoexcited State of Special-Pair Mimic Porphyrin Assemblies Anchored on a Titanium-Modified ITO Anode", CHEMISTRY - A EUROPEAN JOURNAL, vol. 12, no. 31, 25 October 2006 (2006-10-25), pages 8123-8135, XP055053506, ISSN: 0947-6539, DOI: 10.1002/chem.200600304

## Description

### TECHNICAL FIELD

The present invention relates to an electrode consisting of an inorganic material modified with a specific compound and an organic electroluminescence device.

### BACKGROUND ART

Research into devices using organic materials, such as organic electroluminescence devices (hereinafter, also referred to as "OLEDs") and transistors using organic semiconductors, has been actively conducted. Organic electroluminescence devices are particularly promising as solid emission type large-area, full-color display devices and inexpensive large-area surface light sources for lighting applications. A general organic electroluminescence device includes an organic compound layer including a light-emitting layer and a pair of electrodes interposing the organic compound layer therebetween. When a voltage is applied to the organic electroluminescence device, electrons are injected into the organic compound layer from a cathode and holes are injected into the organic compound layer from an anode. The electrons recombine with the holes in the light-emitting layer, and as a result, the energy level returns back to the valence band from the conduction band. At this time, the energy is emitted as light, achieving light emission.

In such a device using an organic material, it is necessary to efficiently inject holes or electrons from a corresponding electrode. Numerous studies have hitherto focused on achieving long lifetime and improved stability of organic electroluminescence devices.

Patent Document 1 describes a long-life organic electroluminescence device in which a phosphate compound having a long-chain alkyl group is used to improve the adhesion between an electrode and an organic layer.

Patent Document 2 describes a photo-organic thin film device in which a phosphite compound having a long-chain alkyl group is chemically bound to the surface of a transparent electrode, achieving good stability without causing any peeling or structural change of a thin film on the electrode. Non-Patent Document 1 describes an organic electroluminescence device using a phosphate compound having an aromatic group. Further, a silane coupling agent having a phenyl group and a silane coupling agent having a long-chain fluorinated alkyl group are known (Non-Patent Document 2), and a silane coupling agent linked to an arylamine is known (Non-Patent Document 3). However, these techniques are still unsatisfactory in terms of efficiency and lifetime.

### PRIOR ART DOCUMENTS

### PATENT DOCUMENTS

Patent Document 1: Japanese Unexamined Patent Publication No. 2004-47176
Patent Document 2: Japanese Unexamined Patent Publication No. 2005-85731

US 2003/087127 A1 describes compounds capable of transporting/injecting holes and an organic EL device comprising a self-assembled monolayer including the compounds, wherein the compounds comprise silane and triphenylamine moieties.

US 2003/162053 A1 describes organic electroluminescent devices with organic films between anodic and cathodic electrodes, wherein the organic films comprise silane and triphenylamine moieties.

US 2005/280604 A1 describes an electrode modificationing molecule with an anchoring group, wherein the modificationing molecule comprises silane and conjugated arylene moieties.

WO 2008/060534 A1 describes printable organic thin- film transistors (OTFT) with a gate insulator layer comprised of nanocomposites incorporating metal oxide nanoparticles coated by organic ligands, wherein the organic ligands comprise phosphone and a N4',N4'-diphenyl-N4-(m-tolyl)-N4'-(o-tolyl)-[1,1'-biphenyl]-4,4'-diamine moiety.

### NON-PATENT DOCUMENTS

Non-Patent Document 1: Advanced Functional Material, Vol. 18, p. 3964, 2008
Non-Patent Document 2: Langmuir, Vol. 23, p. 13223, 2007
Non-Patent Document 3: Accounts of Chemical Research, Vol. 38, p. 632, 2005

Journal of Materials Chemistry 2002, Vol. 12, No. 12, pages 3494-3498 describes the modification of an ITO anode with a hole transporting SAM comprising silane and triphenylamine moieties.

Chemistry - A European Journal 2006, Vol. 12, No. 31, pages 8123-8135 describes porphyrin assemblies anchored on a titanium modified ITO anode.

### SUMMARY OF THE INVENTION

### PROBLEMS TO BE SOLVED BY THE INVENTION

Research efforts have been made in developing high-efficiency organic electroluminescence devices through the modification of electrode surfaces. However, such efforts still remain at an unsatisfactory level.
An object of the present invention is to provide an electrode, and an organic electroluminescence device. A particular object of the present invention is to provide a highly efficient, long-life organic electroluminescence device, and an electrode consisting of an inorganic material modified with a specific compound for use in said organic electroluminescence device.

### MEANS FOR SOLVING THE PROBLEMS

In view of this situation, the present inventor has undertaken extensive studies, and as a result, found that an inorganic material surface-modified with a phosphate compound or a silicon compound having particular substituents can impart very high efficiency and long lifetime to an organic device. Based on this finding, the present inventor has further reviewed and finally achieved the present invention with the electrode and the organic electroluminescence device described in the claims.

### EFFECTS OF THE INVENTION

The present invention can provide a highly efficient, long-life organic electroluminescence device. In addition, the present invention can provide an electrode material for use in the organic electroluminescence device.

### BRIEF DESCRIPTION OF THE DRAWINGS

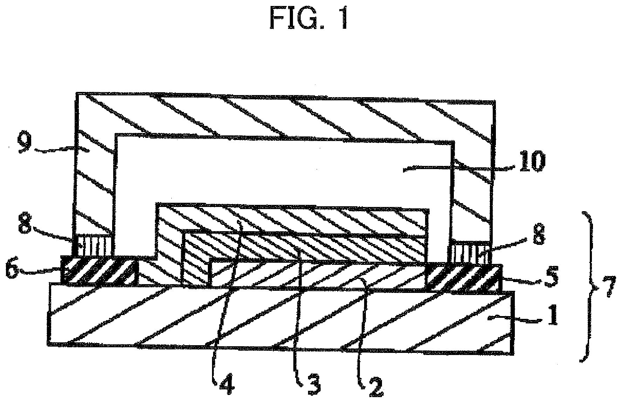

Fig. 1 is a schematic cross-sectional view illustrating an electroluminescence device according to an embodiment of the present invention.

### MODE FOR CARRYING OUT THE INVENTION

The present invention will now be described in detail. A numerical range represented by "to" in the specification represents a range including numerical values described in front of and behind "to" as the minimum value and the maximum value.

### <Inorganic material>

An inorganic material is described characterized by being modified with a compound represented by Formula (1):

Formula (1) T-L-R

(In formula (1), T represents a charge transport moiety containing two or more nitrogen atoms; L represents a divalent linking group or a single bond, R represents-PO(OH)₂ or -SiX₁X₂X₃; X₁, X₂ and X₃ represent leaving groups; and only one-PO(OH)₂ or -SiX₁X₂X₃ is present in one molecule)

Examples of inorganic materials suitable for use in the present invention include silicone, glass, metals, inorganic oxides (for example, silica) and metal oxides (for example, alumina, titanium oxide, tin oxide and indium tin oxide). Glass, inorganic oxides and metal oxides are preferred. Metal oxides are more preferably used. The inorganic material is used for an electrode, particularly a transparent electrode. It is also preferred that the inorganic material is used for an anode. Indium tin oxide (ITO), zinc oxide, tin oxide, etc. are preferably used for transparent electrodes. ITO is more preferred. Details of such inorganic materials are presented in "Trend of the Newest Transparent Conductive Films, published by Johokiko Co. Ltd., 2007 ."

The charge transport moiety of the compound of Formula (1) is fixed to the inorganic material through the phosphoric acid or silane coupling moiety as an adsorbing group. This configuration allows for uniform distribution of the charge transport moieties over the surface of the inorganic material, and is preferable.

The charge transport moiety represented by T in Formula (1) contains two or more nitrogen atoms.

The term "charge" means a positively or negatively charged state and is intended to include the so-called "hole" and "electron." The term "transport" means migration of a charge in a material and is quantitatively expressed by mobility. Specifically, the mobility is preferably in the range of 10⁻¹² cm²/Vs to 10⁵ cm²/Vs, more preferably in the range of 10⁻¹⁰ cm²/Vs to 10 cm²/Vs, particularly preferably in the range of 10⁻⁸ cm²/Vs to 1 cm²/Vs.

Specific examples of hole transport materials including the charge transport moiety containing two or more nitrogen atoms include pyrrole, carbazole, azepine, carbene, triazole, oxazole, oxadiazole, pyrazole, imidazole, pyrazoline, pyrazolone, phenylenediamine, arylamine, amino-substituted chalchone, hydrazone, styrylamine compounds, porphyrin compounds, poly(N-vinylcarbazole), conductive polymer oligomers of aniline copolymers, and derivatives thereof. Two or more skeletons of these materials may be included. T is preferably a group having an arylamine structure, particularly preferably a group having a triarylamine structure. These materials may have further substituents. In this case, the substituents may be selected from the following substituent group V.

The group having a triarylamine structure is preferably represented by Formula (a):

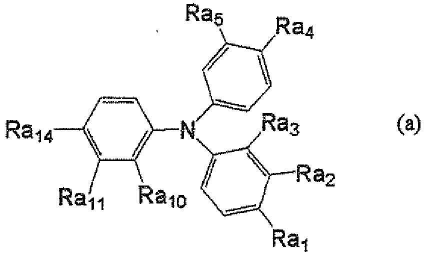

(In formula (a), Ra₁ to Ra₅, Ra₁₀, Ra₁₁ and Ra₁₄ each independently represent a substituent and one of Ra₁ to Ra₅, Ra₁₀, Ra₁₁ and Ra₁₄ is bonded to L in Formula (1))

The substituents represented by Ra₁ to Ra₅, Ra₁₀, Ra₁₁ and Ra₁₄ in Formula (a) are selected from the following substituent group V.

It is preferred that one of Ra₁, Ra₂, Ra₄, Ra₅, Ra₁₁ and Ra₁₄ is bonded to L in Formula (1). It is more preferred that one of Ra₁, Ra₄ and Ra₁₄ is bonded to L in Formula (1). This structure is advantageous because of its appropriate energy level as a charge transport moiety and high adsorptivity for the inorganic material.

In the case where Ra₁ or Ra₂ is bonded to L in Formula (1), Ra₄ or Ra₁₄ is preferably an amino, aryl or heterocyclic group which may be substituted or unsubstituted. Ra₄ or Ra₁₄ is more preferably a diphenylamino or phenyl group. It is even more preferred that the phenyl group has a diphenylamino group as a substituent.

A preferred combination of Ra₁ to Ra₁₀, Ra₁₁ and Ra₁₄ in Formula (a) is that Ra₁ is bonded to L in Formula (1), Ra₄ or Ra₁₄ is an amino, aryl or heterocyclic group, and Ra₂, Ra₃ and Ra₅ to Ra₁₁ are all hydrogen atoms or Ra₂ to Ra₁₁ are all hydrogen atoms.

The ionization potential Ip of the hole transport moiety is preferably from 5.1 eV to 6.3 eV, more preferably from 5.4 eV to 6.1 eV, even more preferably from 5.6 eV to 5.8 eV from the standpoints of improved durability and low driving voltage. The electron affinity Ea of the hole transport moiety is preferably from 1.2 eV to 3.1 eV, more preferably from 1.4 eV to 3.0 eV, even more preferably from 1.8 eV to 2.8 eV from the standpoints of improved durability and low driving voltage.

Specific examples of electron transport materials suitable for use as the charge transport moiety containing two or more nitrogen atoms include pyridine, pyrimidine, triazine, imidazole, pyrazole, triazole, oxazole, oxadiazole, carbodiimide, distyrylpyrazine, phthalocyanine and derivatives thereof (which may form fused rings with other rings), metal complexes and metal phthalocyanines of 8-quinolinol derivatives, and various metal complexes, typified by metal complexes having benzoxazole and benzothiazole ligands.

The electron affinity Ea of the electron transport moiety containing two or more nitrogen atoms is preferably from 2.5 to 3.5 eV, more preferably from 2.6 eV to 3.2 eV, even more preferably from 2.8 eV to 3.1 eV from the standpoints of improved durability and low driving voltage. The ionization potential Ip of the electron transport moiety is preferably from 5.7 eV to 7.5 eV, more preferably from 5.8 eV to 7.0 eV, even more preferably from 5.9 eV to 6.5 eV from the standpoints of improved durability and low driving voltage.

As suitable electron transport moieties, there can be exemplified the compounds described in Japanese Unexamined Patent Publication Nos. 2002-235076, 2004-214179, 2004-221062, 2004-221065, 2004-221068 and 2004-327313. These charge transport moieties may be substituted with deuterium.

L represents a divalent linking group or a single bond. Preferably, L represents a divalent linking group or a single bond, the divalent linking group including an atomic group that consists of one or more atoms selected from the group of carbon, nitrogen, sulfur and oxygen atoms. Examples of such divalent linking groups include C₁-C₂₀ alkylene groups (for example, methylene, ethylene, propylene, butylene, pentylene and cyclohexyl-1,4-diyl groups), C₂-C₂₀ alkenylene groups (for example, an ethenylene group), C₂-C₂₀ alkynylene groups (for example, an ethynylene group), amide groups, ether groups, ester groups, sulfoamide groups, sulfonate groups, ureide groups, sulfonyl groups, sulfinyl groups, thioether groups, carbonyl groups, -NR- groups (wherein R represents a hydrogen atom, an alkyl group or an aryl group), azo groups, azoxy groups, divalent heterocyclic groups (for example, a piperazine-1,4-diyl group), and C₀-C₆₀ divalent linking groups consisting of combinations of two or more thereof.

Preferably, L represents a divalent linking group such as an alkylene group, an alkenylene group, alkynylene group, an ether group, a thioether group, an amide group, an ester group, a carbonyl group, or a combination thereof. More preferably, L is a single bond, an alkylene group, an ether group or a combination thereof.

L may have further substituents. The substituents may be selected from the following substituent group V.

### <Substituent group V>

The substituent group V includes: halogen atoms (for example, chlorine, bromine, iodine and fluorine atoms); mercapto groups; cyano groups; carboxyl groups; phosphoric acid groups; sulfo groups; hydroxyl groups; C₁-C₁₀, preferably C₂-C₈, more preferably C₂-C₅ carbamoyl groups (for example, methylcarbamoyl, ethylcarbamoyl and morpholinocarbamoyl groups); C₀-C₁₀, preferably C₂-C₈, more preferably C₂-C₅ sulfamoyl groups (for example, methylsulfamoyl, ethylsulfamoyl and piperidinosulfamoyl groups); nitro groups; C₁-C₂₀, preferably C₁-C₁₀, more preferably C₁-C₈ alkoxy groups (for example, methoxy, ethoxy, 2-methoxyethoxy and 2-phenylethoxy groups); C₆-C₂₀, preferably C₆-C₁₂, more preferably C₆-C₁₀ aryloxy groups (for example, phenoxy, p-methylphenoxy, p-chlorophenoxy and naphthoxy groups); C₁-C₂₀, preferably C₂-C₁₂, more preferably C₂-C₈ acyl groups (for example, acetyl, benzoyl and trichloroacetyl groups); C₁-C₂₀, preferably C₂-C₁₂, more preferably C₂-C₈ acyloxy groups (for example, acetyloxy and benzoyloxy groups); C₁-C₂₀, preferably C₂-C₁₂, more preferably C₂-C₈ acylamino groups (for example, acetylamino groups); C₁-C₂₀, preferably C₁-C₁₀, more preferably C₁-C₈ sulfonyl groups (for example, methanesulfonyl, ethanesulfonyl and benzenesulfonyl groups); C₁-C₂₀, preferably C₁-C₁₀, more preferably C₁-C₈ sulfinyl groups (for example, methanesulfinyl, ethanesulfinyl and benzenesulfinyl groups); C₁-C₂₀, preferably C₁-C₁₀, more preferably C₁-C₈ sulfonylamino groups (for example, methanesulfonylamino, ethanesulfonylamino and benzenesulfonylamino groups);

C₀-C₂₀, preferably C₀-C₁₂, more preferably C₀-C₈ substituted or unsubstituted amino groups (for example, unsubstituted amino, methylamino, dimethylamino, benzylamino, anilino and diphenylamino groups); C₀-C₁₅, preferably C₃-C₁₀, more preferably C₃-C₆ ammonium groups (for example, trimethylammonium and triethylammonium group); C₀-C₁₅, preferably C₁-C₁₀, more preferably C₁-C₆ hydrazino groups (for example, trimethylhydrazino groups); C₁-C₁₅, preferably C₁-C₁₀, more preferably C₁-C₆ ureide groups (for example, ureide and N,N-dimethylureide groups); C₁-C₁₅, preferably C₁-C₁₀, more preferably C₁-C₆ imide groups (for example, succinimide groups); C₁-C₂₀, preferably C₁-C₁₂, more preferably C₁-C₈ alkylthio groups (for example, methylthio, ethylthio and propylthio groups); C₆-C₈₀, preferably C₆-C₄₀, more preferably C₆-C₃₀ arylthio groups (for example, phenylthio, p-methylphenylthio, p-chlorophenylthio, 2-pyridylthio, 1-naphthylthio, 2-naphthylthio, 4-propylcyclohexyl-4'-biphenylthio, 4-butylcyclohexyl-4'-biphenylthio, 4-pentylcyclohexyl-4'-biphenylthio and 4-propylphenyl-2-ethynyl-4'-biphenylthio groups); C₁-C₈₀, preferably C₁-C₄₀, more preferably C₁-C₃₀ heteroarylthio groups (for example, 2-pyridylthio, 3-pyridylthio, 4-pyridylthio, 2-quinolylthio, 2-furylthio and 2-pyrrolylthio groups);

C₂-C₂₀, preferably C₂-C₁₂, more preferably C₂-C₈ alkoxycarbonyl groups (for example, methoxycarbonyl, ethoxycarbonyl and 2-benzyloxycarbonyl groups); C₆-C₂₀, preferably C₆-C₁₂, more preferably C₆-C₁₀ aryloxycarbonyl groups (for example, phenoxycarbonyl groups); C₁-C₁₈, preferably C₁-C₁₀, more preferably C₁-C₅ unsubstituted alkyl groups (for example, methyl, ethyl, propyl and butyl groups); C₁-C₁₈, preferably C₁-C₁₀, more preferably C₁-C₅ substituted alkyl groups {for example, hydroxymethyl, trifluoromethyl, benzyl, carboxyethyl, ethoxycarbonylmethyl and acetylaminomethyl groups, herein, C₂-C₁₈, preferably C₃-C₁₀, more preferably C₃-C₅ unsaturated hydrocarbon groups (for example, vinyl, ethynyl, 1-cyclohexenyl, benzylidine and benzylidene groups) being also included in the substituted alkyl groups}; C₆-C₂₀, preferably C₆-C₁₅, more preferably C₆-C₁₀ substituted or unsubstituted aryl groups (for example, phenyl, naphthyl, p-carboxyphenyl, p-nitrophenyl, 3,5-dichlorophenyl, p-cyanophenyl, m-fluorophenyl, p-tolyl, 4-propylcyclohexyl-4'-biphenyl, 4-butylcyclohexyl-4'-biphenyl, 4-pentylcyclohexyl-4'-biphenyl and 4-propylphenyl-2-ethynyl-4'-biphenyl); and C₁-C₂₀, preferably C₂-C₁₀, more preferably C₄-C₆ substituted or unsubstituted heterocyclic groups (for example, pyridyl, 5-methylpyridyl, thienyl, furyl, morpholino, tetrahydrofurfuryl and carbazole groups). The substituent group V may also include structures to which benzene rings or naphthalene rings are fused. The substituents may further be substituted with one substituent selected from the substituent group V.

Among the substituents of the substituent group V, preferred are alkyl groups, aryl groups, alkoxy groups, aryloxy groups, fluorine atoms, etc.

L may be substituted with deuterium.

Specifically, L is a single bond, -(CH₂)₃-, -(CH₂)₄-, -(CH₂)₅-, -(CH₂)₆-, -O(CH₂)₃-,-O(CH₂)₄-, -O(CH₂)₅-, -OCO(CH₂)₅-, -O(CH₂)₂O(CH₂)₂-, OCONH(CH₂)₄-, -(CH=CH)-,-NHCO(CH₂)₅- or -CO(CH₂)₄-. A single bond, -O(CH₂)₃-, -(CH₂)₅- or -O(CH₂)₄- is more preferred. The reason for this preference is that the compound can be synthesized at low cost and ensures high durability when applied to a device.

X₁, X₂ and X₃ each independently represent a leaving group. The term "leaving group" is defined as a chemical species that is expelled by an attacking nucleophile. Details of such leaving groups are presented in p. 320 of "Organic Chemistry I," McMurry, translated by Ito, Kodama, et al., Tokyo Kagaku Dojin (1987).

For example, the leaving groups represented by X₁, X₂ and X₃ may be each independently an alkoxy group, an aryloxy group, a halogen atom, an alkylsulfonate, an arylsulfonate and an amino group. Each of the leaving groups is preferably a hydrogen atom, a nitro group, a cyano group, a halogen atom, or a substituted or unsubstituted alkoxy group. Examples of halogen atoms include chlorine, bromine, fluorine and iodine atoms. Chlorine atoms and alkoxy groups (for example, methoxy and ethoxy groups) are more preferred. Alkoxy groups (for example, methoxy, ethoxy, propoxy and butoxy groups) are even more preferred, and methoxy and ethoxy groups are particularly preferred.

The compound of Formula can be synthesized by combinations of various reactions known in the art, for example, the method described in "Compounding Design of Rubber and Nanocomposite" (Edited by Koujiya Shinjo, Nishi Toshio, Yamaguchi Koichi and Akiba Mitsuo, CMC Publishing Co., Ltd., 2003).

Next, a description will be given concerning a method for modifying the inorganic material with the compound represented by Formula (1).

The modification is preferably accomplished by coupling the inorganic material with the compound of Formula (1) to form a covalent bond. When the compound of Formula (1) is a phosphate compound (i.e. R is -PO(OH)₂), the coupling reaction involves dehydration with the inorganic material. Alternatively, when the compound of Formula (1) is a silicon compound (i.e. R is -SiX₁X₂X₃), the coupling reaction involves hydrolysis and dehydration/condensation.

There is no particular restriction on the kind of a solvent used for the reaction. Examples of preferred solvents include water, alcohols, aromatic hydrocarbons, ethers, ketones and esters.

The alcohols can be, for example, monohydric alcohols or dihydric alcohols. The monohydric alcohols are preferably C₁-C₈ saturated aliphatic alcohols. Specific examples of the alcohols include methanol, ethanol, n-propyl alcohol, i-propyl alcohol, n-butyl alcohol, sec-butyl alcohol, tert-butyl alcohol, ethylene glycol, diethylene glycol, triethylene glycol, ethylene glycol monobutyl ether, and ethylene glycol monoethyl ether acetate.

Specific examples of the aromatic hydrocarbons include benzene, toluene and xylene. Specific examples of the ethers include tetrahydrofuran and dioxane. Specific examples of the ketones include acetone, methyl ethyl ketone, methyl isobutyl ketone and diisobutyl ketone. Specific examples of the esters include ethyl acetate, propyl acetate, butyl acetate and propylene carbonate. These organic solvents may be used alone or in combination of two or more thereof.

Although the compound of Formula (1) and the reaction solvent may be used in any weight ratio, the weight ratio of the compound of Formula (1) to the reaction solvent is in the range of 1:0.1 to 1:100, particularly preferably 1:1 to 1:10. The alcohols may be preferably methanol and ethanol.

When the compound of Formula (1) is a silicon compound (i.e. R is -SiX₁X₂X₃), an acid or alkali catalyst may be added during the reaction. The acid catalyst includes, but not particularly limited to, hydrochloric acid, sulfuric acid, phosphoric acid and organic sulfonic acids. The alkali catalyst includes, but not particularly limited to, ammonia, sodium hydroxide, potassium hydroxide, tertiary nitrogen bases (for example, triethylamine) and nitrogen-containing heterocyclic compounds (for example, pyridine). Although the catalyst may be used in any amount, the ratio of the silicon compound to the catalyst is preferably in the range of 1:1 × 10⁻⁶ to 1:1, particularly preferably in the range of 1:1 × 10⁻⁵ to 1:1×10⁻³.

The reaction temperature is not particularly limited but is preferably in the range of 0 °C to 300 °C, particularly preferably in the range of 10 °C to 200 °C. The reaction time is not particularly limited but is preferably in the range of 1 sec to 1,000 hr, particularly preferably in the range of 1 min to 100 hr.

When the compound of Formula (1) is a phosphate compound (i.e. R is -PO(OH)₂), an acid catalyst may be added during the reaction. The acid catalyst includes, but not particularly limited to, hydrochloric acid, sulfuric acid, phosphoric acid and organic sulfonic acids. Although the catalyst may be used in any amount, the ratio of the phosphate compound to the catalyst is preferably in the range of 1:1 × 10⁻⁶ to 1:1, particularly preferably in the range of 1:1 × 10⁻⁵ to 1:1×10⁻³.

The reaction temperature is not particularly limited but is preferably in the range of 0 °C to 300 °C, particularly preferably in the range of 10 °C to 200 °C. The reaction time is not particularly limited but is preferably in the range of 1 min to 1,000 hr, particularly preferably in the range of 10 min to 100 hr.

In the case where an electrode substrate is modified with the compound of the invention, it is preferred that the work function of the modified electrode substrate increases in a positive direction as compared to that of an unmodified electrode substrate. The shift width is preferably in the range of 0.01 to 10 eV, more preferably in the range of 0.05 to 5 eV, particularly preferably in the range of 0.1 to 2 eV.
The work function of an ITO electrode modified with the compound of Formula (1) is preferably in the range of 5.0 to 5.5 eV, more preferably in the range of 5.2 to 5.5 eV. This range is preferred because charges can be efficiently injected into an organic semiconductor compound from the electrode.
The inorganic material modified with the compound of Formula (1) preferably has a contact angle for water in the range of 60° to 100°, more preferably in the range of 80° to 100°, even more preferably in the range of 80° to 92°. This range allows the hydrophilicity and hydrophobicity of the modified inorganic material to reach the same level as those of organic semiconductor compounds generally used in organic devices and organic electroluminescence devices, thus contributing to improvements in adhesiveness and device durability when applied to a device and an organic electroluminescence device.

Specific examples of compounds suitable for use in the present invention (Compounds 1 to 51) and compounds which do not form part of the present invention (Compounds 52 to 59) are described below.

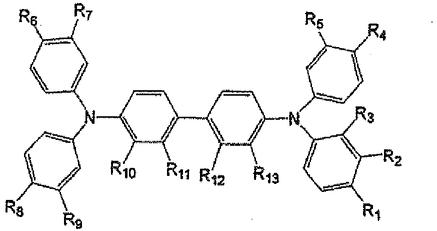

| No. | Adsorbing moiety | Other substituents |
|---|---|---|
| 1 | R1 = (CH₂)₄Si(OEt)₃ | R2-R13 = H |
| 2 | R2 = O(CH₂)₄PO(OH)₂ | R1, R3-R13 = H |
| 3 | R1 = O(CH₂)₃PO(OH)₂ | R7 = Me, R2-R6, R8-R13 = H |
| 4 | R2 = (CH₂)₄PO(OH)₂ | R7, R9 = Me, R1, R3-R6, R8, R10-R13 = H |
| 5 | R1 = OCO(CH₂)₅PO(OH)₂ | R2-R13 = H |
| 6 | R3 = CO(CH₂)₄PO(OH)₂ | R7, R10 = Me, R1, R2, R4-R6, R8, R9, R11 -R13 = H |
| 7 | R1 = O(CH₂)₃PO(OH)₂ | R7 = OMe, R2-R6, R8-R13 = H |
| 8 | R1 = O(CH₂)₅Si(OEt)₃ | R7 = Me, R2-R6, R8-R13 = H |
| 9 | R1 = (CH₂)₄PO(OH)₂ | R7 = Ph, R2-R6, R8-R13 = H |
| 10 | R1 = O(CH₂)₂O(CH₂)₂PO(OH)₂ | R7 = F, R2-R6, R8-R13 = H |
| 11 | R1 = PO(OH)₂ | R2-R13 = H |
| 12 | R1 = PO(OH)₂ | R4, R6 = Me, R2, R3, R5, R7-R13 = H |
| 13 | R2 = O(CH₂)₄Si(OMe)₃ | R5 = Me, R1, R3-R4, R6-R13 = H |
| 14 | R2 = OCONH(CH₂)₄Si(OMe)₃ | R5, R7, R9 = Me, R1, R3, R4, R6, R8, R10-R13 = H |
| 15 | R3 = (CH=CH)PO(OH)₂ | R10, R13 = Me, R1, R2, R4-R9, R11, R12 = H |
| 16 | R1 = NHCO(CH₂)₅PO(OH)₂ | R11, R12 = Me, R2-R10, R13 =H |

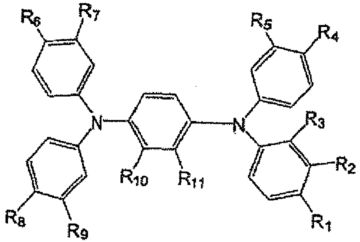

| No. | Adsorbing moiety | Other substituents |
|---|---|---|
| 17 | R1 = Q(CH₂)₅PO(OH)₂ | R2-R11 = H |
| 18 | R2 = O(CH₂)₄PO(OH)₂ | R1, R3-R11 = H |
| 19 | R1 = O(CH₂)₃PO(OH)₂ | R3 = Me, R2, R4-R11 = H |
| 20 | R2 = (CH₂)₄PO(OH)₂ | R7, R9 = Me, R1, R3-R6, R8, R10, R31 = H |
| 21 | R1 = OCO(CH₂)₅PO(OH)₂ | R2-R11 = H |
| 22 | R3 = CO(CH₂)₄PO(OH)₂ | R7, R10 = Me, R1, R2, R4-R6, R8, R9, R11 = H |
| 23 | R1 = O(CH₂)₃PO(OH)₂ | R7 = OMe, R2-R6, R8-R11 = H |
| 24 | R1 = O(CH₂)₅PO(OH)₂ | R7 = Et, R2-R6, R8-R11 = H |
| 25 | R1 = (CH₂)₄Si(OMe)₃ | R7 = Ph, R2-R6, R8-R11 = H |
| 26 | R1 = O(CH₂)₂O(CH₂)₂PO(OH)₂ | R7 = F, R2-R6, R8-R11 = H |
| 27 | R1 = PO(OH)₂ | R2-R11 = H |
| 28 | R1 = Si(OMe)₃ | R7, R8 = Ph, R2-R6, R8, R10, R11 = H |
| 29 | R2 = O(CH₂)₄Si(OEt)₃ | R5 = Me, R1, R3-R4, R6-R11 = H |
| 30 | R2 = OCONH(CH₂)₃PO(OH)₂ | R5, R7, R9 = Me, R1, R3, R4, R6, R8, R10, R11 = H |
| 31 | R3 = (CH=CH)Si(OMe)₃ | R10 = Me, R1, R2, R4-R9, R11 = H |
| 32 | R1 = NHCO(CH₂)₅PO(OH)₂ | R11 = Me, R2-R10 =H |

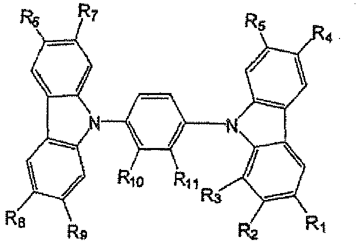

| No. | Adsorbing moiety | Other substituents |
|---|---|---|
| 33 | R1 = O(CH₂)₅PO(OH)₂ | R2-R11 = H |
| 34 | R2 = O(CH₂)₄PO(OH)₂ | R1, R3-R11 = H |
| 35 | R1 = O(CH₂)₃PO(OH)₂ | R7 = Me, R2-R6, R8-R11 = H |
| 36 | R2 = (CH₂)₄PO(OH)₂ | R7, R9 = Me, R1, R3-R6, R8, R10, R11 = H |
| 37 | R1 = OCO(CH₂)₄Si(OMe)₃ | R2-R11 = H |
| 38 | R3 = CO(CH₂)₄PO(OH)₂ | R7, R10 = Me, R1, R2, R4-R6, R8, R9, R11 = H |
| 39 | R1 = O(CH₂)₃PO(OH)₂ | R7 = OMe, R2-R6, R8-R11 = H |
| 40 | R1 = O(CH₂)₄Si(OMe)₃ | R7 = Et, R2-R6, R8-R11 = H |
| 41 | R1 = (CH₂)₄PO(OH)₂ | R7 = Ph, R2-R6, R8-R11 = H |
| 42 | R1 = SiO(Me)₃ | R7 = F, R2-R6, R8-R11 = H |
| 43 | R1 = PO(OH)₂ | R2-R11 = H |

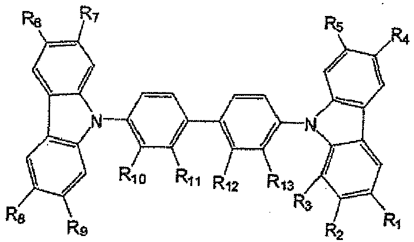

| No. | Adsorbing moiety | Other substituents |
|---|---|---|
| 44 | R1 = O(CH₂)₅PO(OH)₂ | R2-R13 = H |
| 45 | R2 = O(CH₂)₄PO(OH)₂ | R1, R3-R13 = H |
| 46 | R1 = O(CH₂)₃PO(OH)₂ | R7 = Me, R2-R6, R8-R13 = H |
| 47 | R2 = (CH₂)₄PO(OH)₂ | R7, R9 = Me, R1, R3-R6, R8, R10-R13 = H |
| 48 | R1 = OCO(CH₂)₅PO(OH)₂ | R2-R13 = H |
| 49 | R3 = CO(CH₂)₄PO(OH)₂ | R7, R10, R13 = Me, R1, R2, R4-R6, R8, R9, R11, R12 = H |
| 50 | R1 = P(CH₂)₄SiCl₃ | R7 = OMe, R2-R6, R8-R13 = H |
| 51 | R1 = PO(OH)₂ | R2-R13 = H |

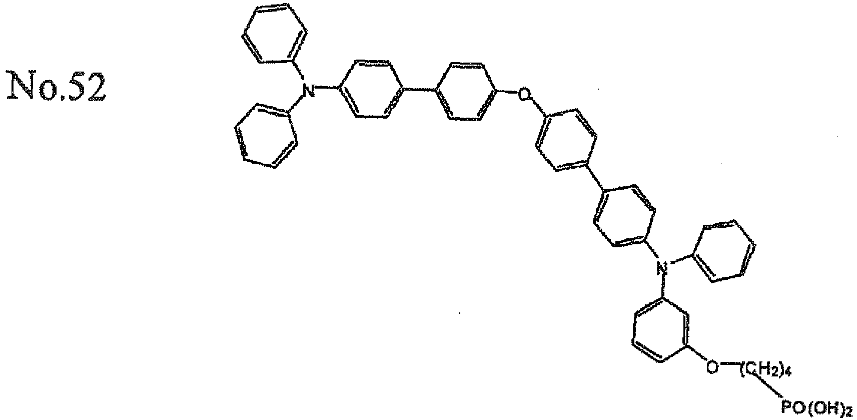

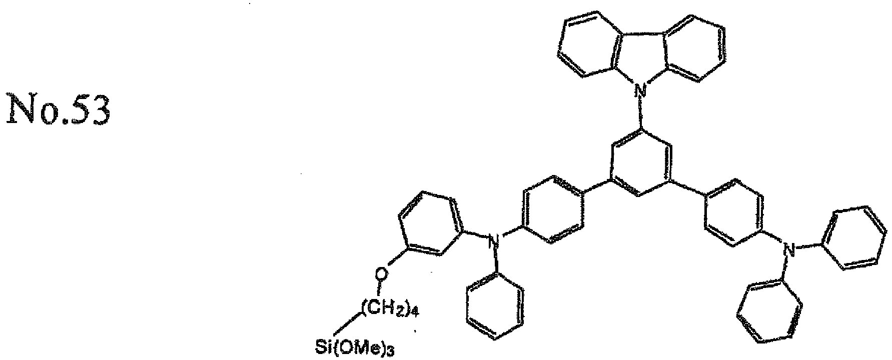

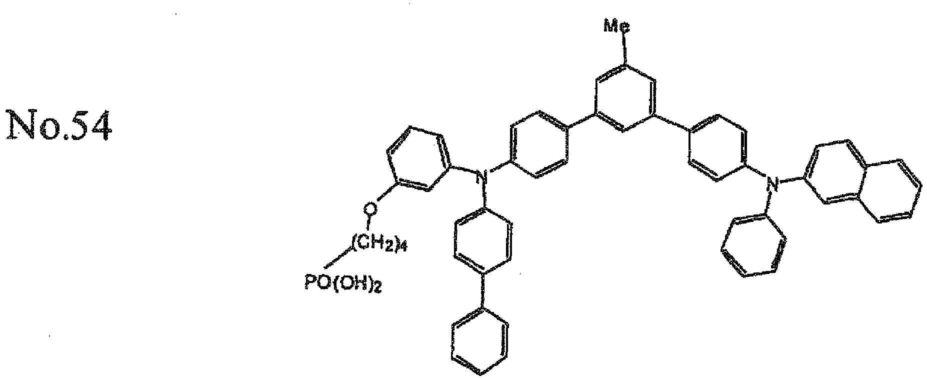

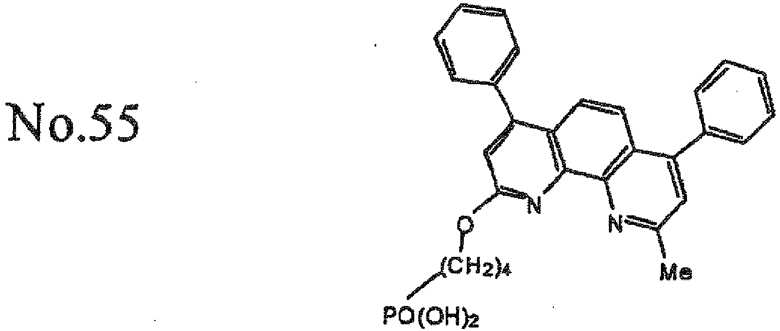

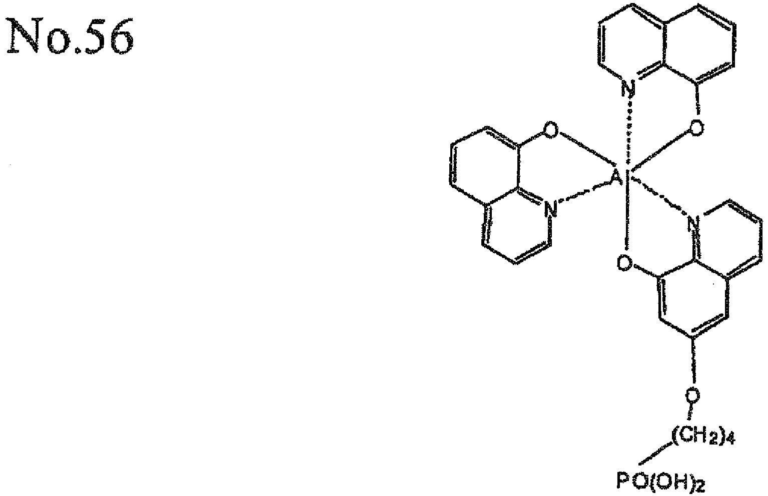

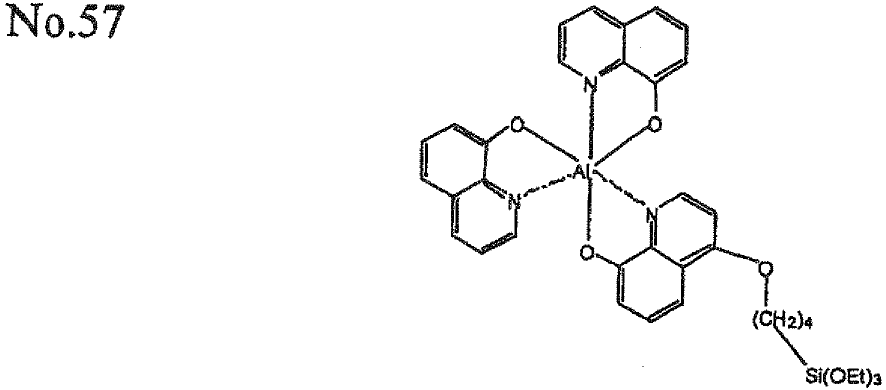

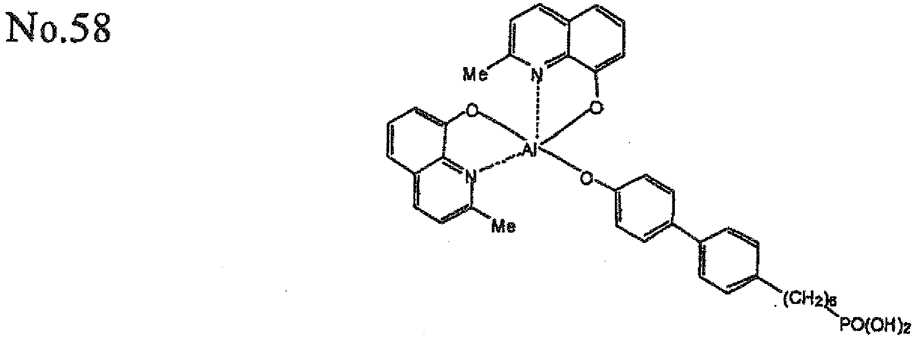

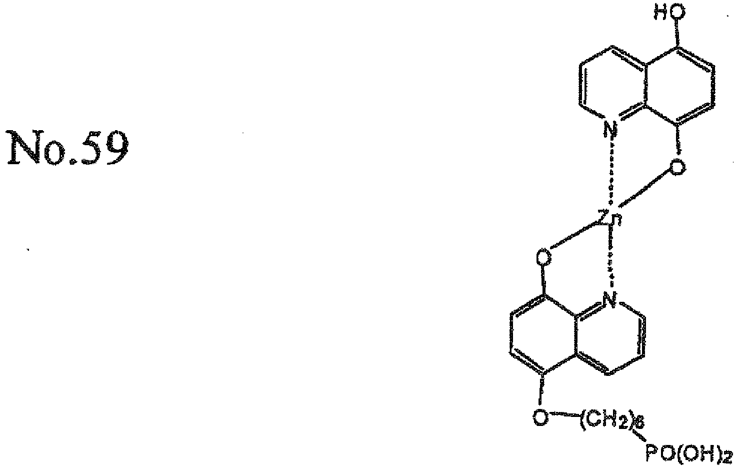

### <Organic electroluminescence device>

Hereinafter, a description will be given concerning the organic electroluminescence device described.

The organic electroluminescence device uses the inorganic material modified with the compound of Formula (1). The inorganic material is preferably indium tin oxide (ITO). The inorganic material is preferably an anode.

The organic electroluminescence device has a light-emitting laminate consisting of a transparent electrode, which uses the inorganic material modified with the compound of Formula (1), at least one organic compound layer and a back electrode laminate on a substrate. The organic compound layer includes a light-emitting layer. The light-emitting layer preferably contains a phosphorescent compound. The device may further include organic compound layers other than the light-emitting layer, or protective layers and sealing layers, if necessary.

Preferably, oxygen is present at a low concentration in the device. The concentration of oxygen in the device is 100 ppm or lower, preferably 50 ppm or lower. No particular limitation is imposed on a method for creating an atmosphere containing oxygen at a concentration not higher than 100 ppm. For example, the device may be sealed in an inert gas atmosphere containing oxygen at a concentration not higher than 100 ppm. The inert gas is preferably nitrogen, argon, etc. in terms of cost and ease of handling.

A sealing member, such as a sealing cap or a sealing cover, may be used for sealing. Any material having low moisture and oxygen permeability may be used for the sealing member, and specific examples thereof include: glass; inorganic materials, such as ceramics;
metals, such as stainless steel, iron and aluminum; polyesters, such as polyethylene terephthalate, polybutylene terephthalate and polyethylene naphthalate; and polymeric materials, such as polystyrene, polycarbonate, polyethersulfone, polyarylate, allyl diglycol carbonate, polyimide, polycycloolefin, norbornene resins, poly(chlorotrifluoroethylene), Teflon (Registered trademark) and polytetrafluoroethylene-polyethylene copolymers. The use of the polymeric materials is preferred in the fabrication of flexible electroluminescence devices and coating type electroluminescence devices.

An appropriate sealant (adhesive) may be used to dispose the sealing member on the light-emitting laminate. The sealant may be, for example, a UV curable resin, a heat curable resin, a two-component curable resin, a moisture curable resin, an anaerobic curable resin or a hot-melt resin.

Fig. 1 is a schematic cross-sectional view illustrating an electroluminescence device according to an embodiment of the present invention. The electroluminescence device illustrated in Fig. 1 has a light-emitting laminate 7 having a transparent electrode 2, an organic compound layer 3 and a back electrode 4 formed on a substrate 1, and a sealing member 9 sealing the organic compound layer 3. In this embodiment, the sealing member 9 is adhered to the substrate 1, a transparent electrode lead 5 and a back electrode lead 6 by means of a sealant (adhesive) 8 and is disposed on the light-emitting laminate 7. A moisture absorbent or an inert liquid may be injected into a space 10. The moisture absorbent includes, but not particularly limited to, barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieves, zeolite and magnesium oxide. Examples of usable inert liquids include paraffins, liquid paraffins, fluorinated solvents (for example, perfluoroalkanes, perfluoroamines and perfluoroethers), chlorinated solvents and silicone oils.

For example, the light-emitting laminate of the electroluminescence device according to the present invention may have a structure of: transparent electrode/light-emitting layer/back electrode, transparent electrode/light-emitting layer/electron transporting layer/back electrode; transparent electrode/hole transporting layer/light-emitting layer/electron transporting layer/back electrode; transparent electrode/hole transporting layer/light-emitting layer/back electrode; transparent electrode/light-emitting layer/electron transporting layer/electron injection layer/back electrode; or transparent electrode/hole injection layer/hole transporting layer/light-emitting layer/electron transporting layer/electron injection layer/back electrode laminated in this order or a reverse order on a substrate. The light-emitting layer contains a phosphorescent compound and light is normally outputted from the transparent electrode. Details of compounds used in the respective layers are presented, for example, in "Organic EL Displays" (Technotimes), a separate volume of "Monthly Display," the October issue of 1998.

Although the organic compound layer may be formed in any position without particular limitation, and the position of the organic compound layer may be appropriately selected according to the intended application and purpose of the electroluminescence device, it is preferred to form the organic compound layer on the transparent electrode or the back electrode. The organic compound layer may be formed over the entire surface of the transparent electrode or the back electrode or on a portion of the surface of the transparent electrode or the back electrode. The shape, size and thickness of the organic compound layer may be appropriately selected according to the intended purpose.

The organic compound layer may be formed by a dry or wet process (coating process). The use of a wet process is preferred in that the organic compound layer can be easily formed on a large area and the electroluminescence device can be fabricated with high luminance and luminescence efficiency in an economical and efficient manner. Examples of dry processes suitable for forming the organic compound layer include deposition and sputtering. Examples of wet processes suitable for forming the organic compound layer include dipping, spin coating, dip coating, casting, die coating, roll coating, bar coating and gravure coating. These processes can be appropriately selected according to the kind of materials for the organic compound layer. The wet process may be followed by drying after film formation. Drying is performed under suitable conditions. For example, drying temperature and pressure conditions are appropriately selected such that the coating layer is not damaged.

The organic electroluminescence device using the modified inorganic material according to the present invention is preferably fabricated by at least one coating process.

A coating solution used for the wet process is commonly composed of a material for the organic compound layer and a solvent for dissolving or dispersing the material. The solvent is not particularly limited and is selected depending on the material for the organic compound layer. Specific examples of solvents suitable for use in the coating solution include halogen-based solvents (for example, chloroform, carbon tetrachloride, dichloromethane, 1,2-dichloroethane and chlorobenzene), ketone-based solvents (for example, acetone, methyl ethyl ketone, diethyl ketone, n-propyl methyl ketone and cyclohexanone), aromatic solvents (for example, benzene, toluene and xylene), ester-based solvents (for example, ethyl acetate, n-propyl acetate, n-butyl acetate, methyl propionate, ethyl propionate, γ-butyrolactone and diethyl carbonate), ether-based solvents (for example, tetrahydrofuran and dioxane), amide-based solvents (for example, dimethylformamide and dimethylacetamide), dimethyl sulfoxide, and water. The solids content of the coating solution is not particularly limited and the viscosity of the coating solution may be arbitrarily selected according to the process type.

The electroluminescence device of the present invention usually emits light when a direct current voltage (which may include an alternating current component) of about 2 to about 40 V or a direct current is applied between the transparent electrode and the back electrode. The electroluminescence device of the present invention may be driven by the methods described, for example, in Japanese Unexamined Patent Publication Nos. Hei 2-148687, Hei 6-301355, Hei 5-29080, Hei 7-134558, Hei 8-234685 and Hei 8-241047, U.S. Patent Nos. 5828429, and 6023308, and Japanese Patent No. 2784615. A detailed explanation will be given concerning the constituent layers of the light-emitting laminate, but the present invention is not limited thereto.

### (A) Substrate

The substrate is preferably made of a material which is impermeable or substantially impermeable to moisture. Preferably, the material does not scatter or attenuate light emitted from the organic compound layer. Specific examples of suitable materials for the substrate include: inorganic materials, such as yttria-stabilized zirconia (YSZ) and glass; polyesters, such as polyethylene terephthalate, polybutylene terephthalate and polyethylene naphthalate; and organic materials, such as polystyrene, polycarbonate, polyethersulfone, polyarylate, allyl diglycol carbonate, polyimide, polycycloolefin, norbornene resins and poly(chlorotrifluoroethylene). Of these, the organic materials are particularly preferred due to their good heat resistance, dimensional stability, solvent resistance, electrical insulation and processability, low air-permeability and low moisture absorptivity. The substrate materials may be used either singly or in combination of two or more thereof. The substrate material can be suitably selected depending on a material for the transparent electrode. For example, in the case where the transparent electrode is made of indium tin oxide (ITO), it is preferred that the substrate is made of a material whose lattice constant is close to that of ITO.

The shape, structure, size, etc. of the substrate can be suitably selected according to the intended application and purpose of the electroluminescence device. The substrate is generally plate-like in shape. The substrate may have a monolayer or laminated structure. The substrate may be colorless or colored transparent but is preferably a colorless transparent one in that light emitted from the light-emitting layer is not scattered or attenuated.

A moisture permeation-preventing layer (gas barrier layer) may be formed on the surface of the substrate toward or opposite to the electrodes. Alternatively, moisture permeation-preventing layers may be formed on both surfaces of the substrate. The moisture permeation-preventing layer is preferably formed of an inorganic material such as silicon nitride or silicon oxide. The moisture permeation-preventing layer can be formed by radio-frequency sputtering. If necessary, a hard coating layer or an undercoating layer may be formed on the substrate.

### (B) Transparent electrode

Generally, the transparent electrode functions as an anode for supplying holes to the organic compound layer. Alternatively, the transparent electrode may function as a cathode. In this case, the back electrode functions as an anode. The transparent electrode functioning as an anode will be explained below.

The shape, structure, size, etc. of the transparent electrode can be suitably selected without particular limitation according to the intended application and purpose of the electroluminescence device. The transparent electrode may be made of, for example, a metal, an alloy, a metal oxide, an electrically conductive compound, or a mixture thereof. The material for the transparent electrode preferably has a work function of at least 4 eV. Specific examples of suitable materials for the transparent electrode include antimony-doped tin oxide (ATO), fluorine-doped tin oxide (FTO), semiconductive metal oxides (for example, tin oxide, zinc oxide, indium oxide, indium tin oxide (ITO) and indium zinc oxide (IZO)), metals (for example, gold, silver, chromium and nickel), mixtures and laminates of the metals and the conductive metal oxides, inorganic conductive materials (for example, copper iodide and copper sulfide), organic conductive materials (for example, polyaniline, polythiophene and polypyrrole), and laminates of the organic conductive materials and ITO.

The transparent electrode may be formed on the substrate by any suitable process, for example: a wet process, such as printing or coating; a physical process, such as vacuum deposition, sputtering or ion plating; or a chemical process, such as CVD or plasma CVD. A suitable process for forming the transparent electrode may be selected taking into consideration its suitability for the transparent electrode material. For example, in the case where ITO is used as a material for the transparent electrode, DC or radio-frequency sputtering, vacuum deposition, ion plating, etc. may be used. Alternatively, in the case where an organic conductive material is used as a material for the transparent electrode, a wet process may be used.

The transparent electrode may be patterned by any suitable process, for example, chemical etching such as photolithography, or physical etching such as laser etching. The patterning may also be performed by vacuum deposition or sputtering using a mask, lift off, printing, etc.

The position of the transparent electrode may be appropriately selected according to the intended application and purpose of the electroluminescence device. It is preferred to form the transparent electrode on the substrate. The transparent electrode may be formed over the entire surface of the substrate or on a portion of the surface of the substrate.

The thickness of the transparent electrode may be suitably selected according to the material for the transparent electrode and is typically from 10 nm to 50 µm, preferably from 50 nm to 20 µm. The resistance of the transparent electrode is preferably limited to 10³ Ω/□ (Ω/square) or below, more preferably to 10² Ω/□ or below. The transparent electrode may be colorless or colored transparent. The transparent electrode preferably has a transmittance of 60% or more, more preferably 70% or more, which allows light to emit from the transparent electrode. The transmittance of the transparent electrode can be measured by a known method using a spectrophotometer.

Electrodes described in detail in "Development of Transparent Conductive Films" (Supervised by Yutaka Sawada, published by CMC Publishing Co., Ltd., 1999) can also be applied to the present invention. Particularly, in the case where a plastic substrate having low heat resistance is used, it is preferred to form the transparent electrode using ITO or IZO at a temperature of 150 °C or lower.

### (C) Back electrode

Generally, the back electrode functions as a cathode for injecting electrons into the organic compound layer. Alternatively, the back electrode may function as an anode. In this case, the transparent electrode functions as a cathode. The back electrode functioning as a cathode will be explained below.

The shape, structure, size, etc. of the back electrode can be suitably selected without particular limitation according to the intended application and purpose of the electroluminescence device. The back electrode may be made of, for example, a metal, an alloy, a metal oxide, an electrically conductive compound, or a mixture thereof. The material for the back electrode preferably has a work function of 4.5 eV or less. Specific examples of suitable materials for the back electrode include alkali metals (for example, Li, Na, K and Cs), alkaline-earth metals (for example, Mg and Ca), gold, silver, lead, aluminum, sodium-potassium alloys, lithium-aluminum alloys, magnesium-silver alloys, indium, and rare earth metals (for example, ytterbium). These materials may be used alone but, preferably, are used in combination of two or more thereof in terms of both stability and electron injectability. Of these materials, alkali metals and alkaline-earth metals are preferred in terms of electron injectability, and aluminum-based materials are preferred in terms of storage stability. The term "aluminum-based materials" is intended to include aluminum as well as aluminum alloys containing 0.01 to 10% by weight of an alkali metal, an alkaline-earth metal or a mixture (for example, lithium-aluminum alloys and magnesium-aluminum alloys). The materials described in detail, for example, in Japanese Unexamined Patent Publication Nos. Hei 2-15595 and Hei 5-121172 can also be used for the back electrode.

The back electrode may be formed by any suitable process, for example: a wet process, such as printing or coating; a physical process, such as vacuum deposition, sputtering or ion plating; or a chemical process, such as CVD or plasma CVD. A suitable process for forming the back electrode may be selected taking into consideration its suitability for the back electrode material. For example, two or more kinds of metals may be used to form the back electrode. In this case, the materials may be sputtered simultaneously or sequentially.

The back electrode may be patterned by any suitable process, for example, chemical etching such as photolithography, or physical etching such as laser etching. The patterning may also be performed by vacuum deposition or sputtering using a mask, lift off, printing, etc.

The position of the back electrode may be appropriately selected according to the intended application and purpose of the electroluminescence device. It is preferred to form the back electrode on the organic compound layer. The back electrode may be formed over the entire surface of the organic compound layer or on a portion of the surface of the organic compound layer. A dielectric layer may be formed between the back electrode and the organic compound layer. The dielectric layer may be formed of an alkali metal or alkaline-earth metal fluoride and may have a thickness of 0.1 to 5 nm. The dielectric layer may be formed by a suitable process, such as vacuum deposition, sputtering or ion plating.

The thickness of the back electrode may be suitably selected according to the material for the back electrode and is typically from 10 nm to 5 µm, preferably from 50 nm to 1 µm. The back electrode may be transparent or opaque. The transparent back electrode may be formed by forming a layer of the above-mentioned material to a thickness of 1 to 10 nm and laminating a layer of a transparent conductive material, such as ITO or IZO, thereon.

### (D) Light-emitting layer

The light-emitting layer of the electroluminescence device according to the present invention may contain a phosphorescent compound. Any phosphorescent compound capable of emitting light from triplet excitons may be used without particular limitation in the present invention. The phosphorescent compound is preferably an ortho-metallized complex or a porphyrin complex, more preferably an ortho-metallized complex. The porphyrin complex is preferably a porphyrin platinum complex. The phosphorescent compound may be used alone or in combination with one or two other phosphorescent compounds.

The term "ortho-metallized complex" is a generic name of a group of compounds described, for example, in Akio Yamamoto, "Organometallic Chemistry, Foundations and Applications," pp. 150-232, Shokabo (1982), and H. Yersin, "Photochemistry and Photophysics of Coordination Compounds," pp. 71-77 and pp. 135-146, Springer-Verlag (1987).

The ligand of the ortho-metallized complex is not particularly limited, but is preferably selected from 2-phenylpyridine derivatives, 7,8-benzoquinoline derivatives, 2-(2-thienyl)pyridine derivatives, 2-(1-naphthyl)pyridine derivatives and 2-phenylquinoline derivatives. These derivatives may have one or more substituents. The ortho-metallized complexes may have ligands other than their essential ligands. Any transition metal may be used as a center metal of the ortho-metallized complex. Examples of center metals suitable for use in the present invention include rhodium, platinum, gold, iridium, ruthenium and palladium. Of these, iridium is particularly preferred. The organic compound layer has high luminance and luminescence efficiency due to the presence of the ortho-metallized complex. Details of ortho-metallized complexes are also found in Paragraphs 0152-0180 of Japanese Patent Application No. 2000-254171.

The ortho-metallized complex used in the present invention can be synthesized by the known methods described, for example, in Inorg. Chem., 30, 1685, 1991, Inorg. Chem., 27, 3464, 1988, Inorg. Chem., 33, 545, 1994, Inorg. Chim. Acta, 181, 245, 1991, J. Organomet. Chem., 335, 293, 1987, and J. Am. Chem. Soc., 107, 1431, 1985.

The content of the phosphorescent compound in the light-emitting layer is, for example, from 0.1 to 70% by weight, preferably from 1 to 20% by weight, but is not particularly limited thereto. When the phosphorescent compound is present in an amount of 0.1 to 70% by weight, effects thereof are sufficiently exhibited.

If necessary, the light-emitting layer may further contain a host compound, a hole transport material, an electron transport material, an electrically inactive polymer binder, etc.

Descriptions regarding the host compound, the hole transport material, the electron transport material and the electrically inactive polymer binder can be found in Paragraphs [0044]-[0048] of Japanese Unexamined Patent Publication No. 2002-246172.

The thickness of the light-emitting layer is preferably from 10 to 200 nm, more preferably from 20 to 80 nm. When the light-emitting layer is thinner than 200 nm, a rise in driving voltage can be inhibited. Meanwhile, when the light-emitting layer is thicker than 10 nm, the electroluminescence device can be protected against short-circuiting.

### (E) Electron transport layer

If necessary, the electroluminescence device of the present invention may have an electron transport layer formed of the electron transport material described above. The electron transport layer may contain the polymer binder described above. The thickness of the electron transport layer is preferably 10 to 200 nm, more preferably 20 to 80 nm. When the electron transport layer is thinner than 200 nm, a rise in driving voltage can be inhibited. Meanwhile, when the electron transport layer is thicker than 10 nm, the electroluminescence device can be protected against short-circuiting.

### (F) Hole transport layer

If necessary, the electroluminescence device of the present invention may have a hole transport layer formed of the electron transport material described above. The hole transport layer may contain the polymer binder described above. The thickness of the hole transport layer is preferably 10 to 200 nm, more preferably 20 to 80 nm. When the hole transport layer is thinner than 200 nm, a rise in driving voltage can be inhibited. Meanwhile, when the hole transport layer is thicker than 10 nm, the electroluminescence device can be protected against short-circuiting.

### (G) Others

The electroluminescence device of the present invention may have one of the protective layers described, for example, in Japanese Unexamined Patent Publication Nos. Hei 7-85974, Hei 7-192866, Hei 8-22891, Hei 10-275682 and Hei 10-106746. The protective layer is formed on the uppermost surface of the electroluminescence device. When the substrate, the transparent electrode, the organic compound layer and the back electrode are laminated in this order, the uppermost surface of the electroluminescence device indicates the outer surface of the back electrode. When the substrate, the back electrode, the organic compound layer and the transparent electrode are laminated in this order, the uppermost surface of the electroluminescence device indicates the outer surface of the transparent electrode. The shape, size, thickness, etc. of the protective layer are not particularly limited. Any material may be used to form the protective layer so long as it can inhibit factors (e.g., moisture and oxygen) deteriorating the functions of the electroluminescence device from entering or permeating the device. Examples of suitable materials for the protective layer include silicon monoxide, silicon dioxide, germanium monoxide and germanium dioxide.

The protective layer may be formed by any suitable method, for example, vacuum deposition, sputtering, reactive sputtering, molecular beam epitaxy, cluster ion beam, ion plating, plasma polymerization, plasma CVD, laser CVD, thermal CVD or coating.

The electroluminescence device of the present invention may have a sealing layer to prevent permeation of moisture and oxygen. Examples of materials for the sealing layer include copolymers of tetrafluoroethylene and at least one comonomer, fluorine-containing copolymers having a cyclic structure in the main chain thereof, polyethylene, polypropylene, polymethyl methacrylate, polyimide, polyurea, polytetrafluoroethylene, polychlorotrifluoroethylene, polydichlorodifluoroethylene, copolymers of chlorotrifluoroethylene and other comonomers, copolymers of dichlorodifluoroethylene and other comonomers, moisture-absorbing materials having a water absorption rate of 1% or more, moisture-proofing materials having a water absorption rate of 0.1% or less, metals (for example, In, Sn, Pb, Au, Cu, Ag, Al, Tl and Ni), metal oxides (for example, MgO, SiO, SiO₂, Al₂O₃, GeO, NiO, CaO, BaO, Fe₂O₃, Y₂O₃ and TiO₂), metal fluorides (for example, MgF₂, LiF, AlF₃ and CaF₂), liquid fluorinated carbons (for example, perfluoroalkanes, perfluoroamines and perfluoroethers), and dispersions of a moisture or oxygen adsorbent in the liquid fluorinated carbons.

### <Applications>

When the electrode of the present invention is applied to an organic electroluminescence device, it can impart high efficiency and long-term lifetime to the organic electroluminescence device. Therefore, the electrode of the present invention is preferably applied to a surface light source for a full-color display, a backlight or a lighting system, a light source array for a printer, etc.

### EXAMPLES

The present invention will be explained in more detail with reference to the following examples. Those skilled in the art may appropriately select materials, reagents, amounts and ratios thereof, operations, etc. shown in the following examples.
It should be understood that the scope of the present invention is not limited by the examples in any manner.

### [Synthesis Example 1]

### (Synthesis of compound 3)

Compound 3 was synthesized by the following reaction scheme.

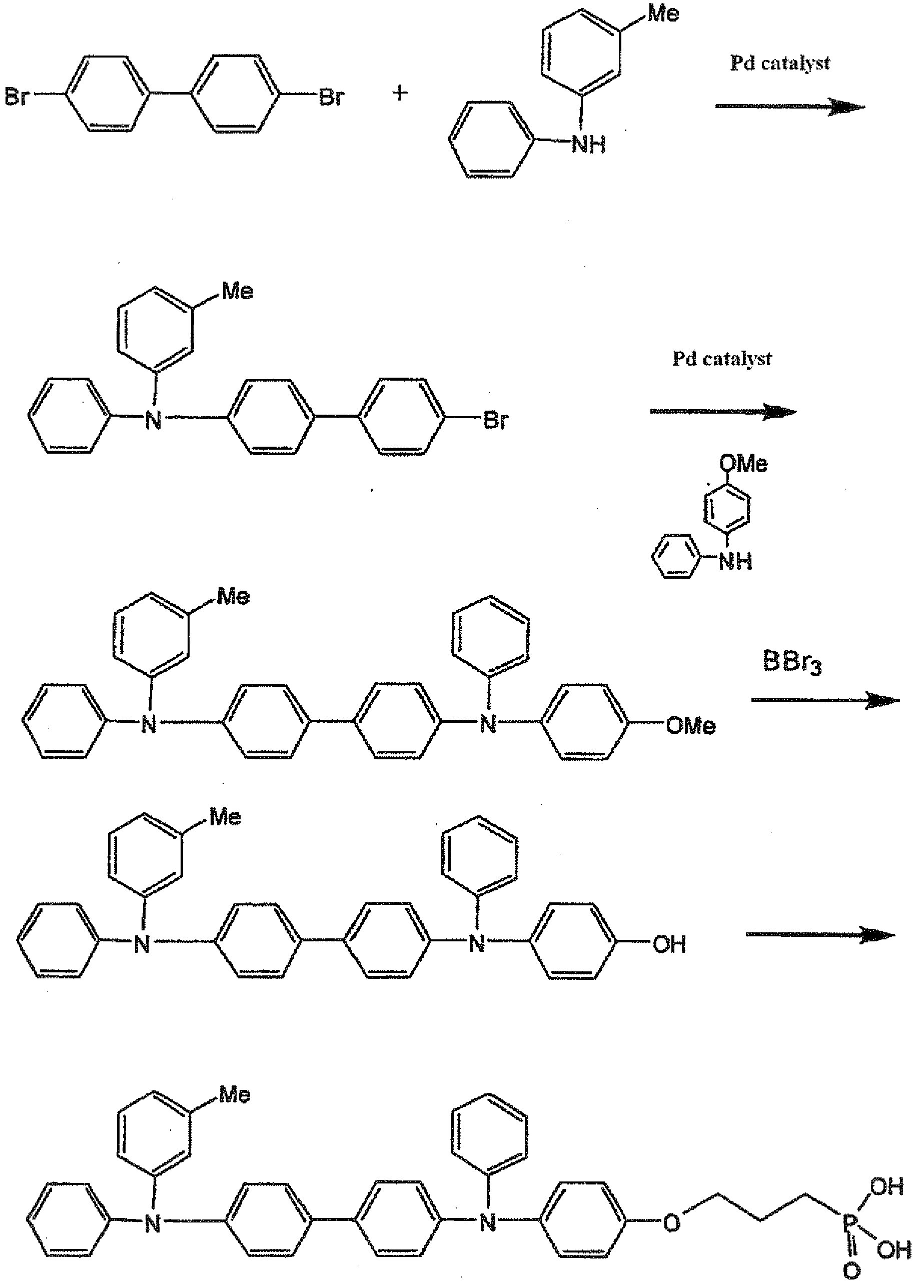

### <Synthesis Example 2>

### (Synthesis of compound 8)

Compound 8 was synthesized by the following reaction scheme.

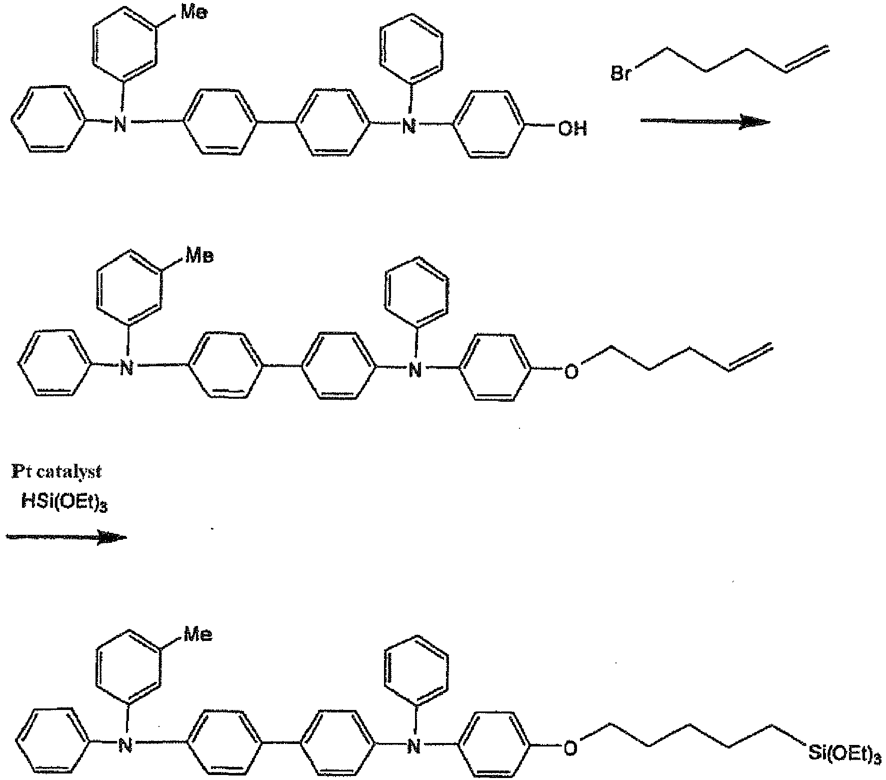

### <Synthesis Example 3>

### (Synthesis of compound 19)

Compound 19 was synthesized by the following reaction scheme.

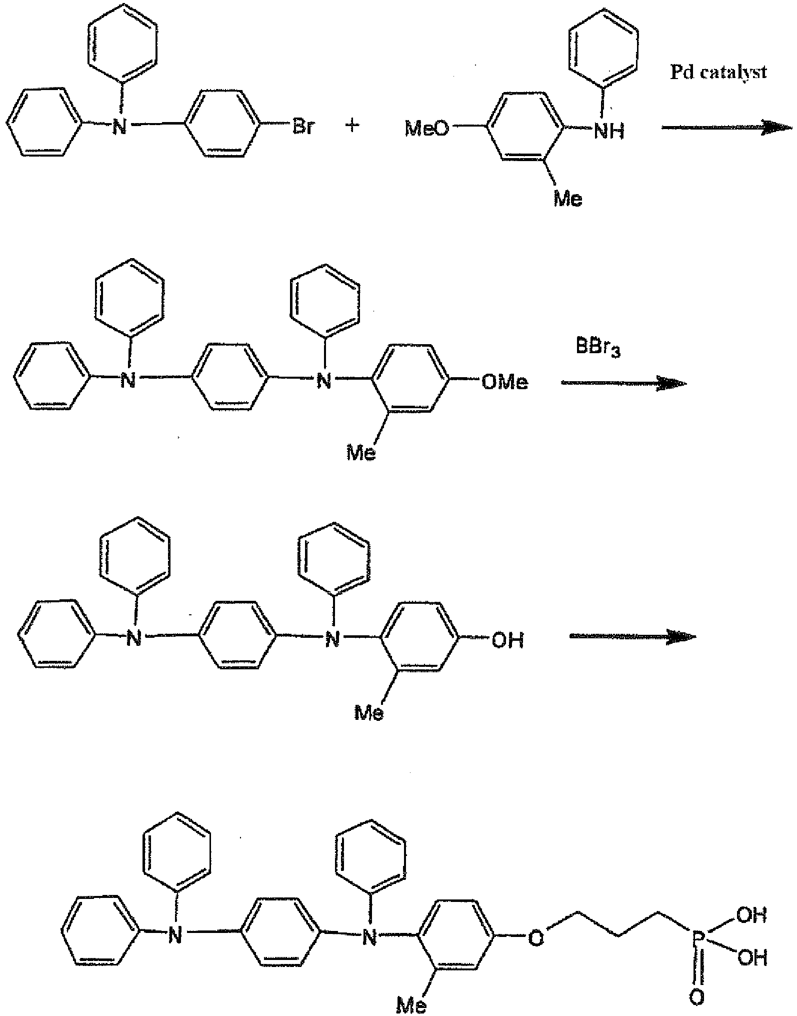

### <Example 1>

### (Modification of inorganic materials)

50 mg of each of the inventive compounds shown in Table 1 and the known compounds were dissolved in toluene. 50 ml of the toluene solution was applied to a wet thickness of 1 µm onto a glass substrate (10 cm x 10 cm, manufactured by IGC Corporation, pretreated with UV ozone) coated with indium tin oxide (ITO) as a transparent electrode by spin coating. The substrate was heated at 100 °C for 1 hour, dipped in an aqueous solution of isopropanol (1%) in acetic acid (90 wt%) for 10 min, washed with isopropanol and acetone, and dried.

### (Performance evaluation)

The hydrophilicity and hydrophobicity of the obtained inorganic material substrate were evaluated by measuring the contact angle of a droplet at room temperature. The work function of the inorganic material substrate was evaluated using a photoelectron spectroscopy (AC-2/AC-3, manufactured by Riken) in air. The results are shown below.

**[TABLE 1]**

| Sample No. | Compound No. | Contact angle (°) | Work function (eV) | Remark |
|---|---|---|---|---|
| 1 | 1 | 80 | 5.20 | Inventive |
| 2 | 3 | 92 | 5.20 | Inventive |
| 3 | 8 | 90 | 5.47 | Inventive |
| 4 | 12 | 90 | 5.30 | Inventive |
| 5 | 19 | 80 | 5.50 | Inventive |
| 6 | 23 | 80 | 5.35 | Inventive |
| 7 | 29 | 85 | 5.40 | Inventive |
| 8 | Unmodified | 60 | 4.84 | Comparative |
| 9 | Ph-PA | 45 | 4.85 | Comparative |
| 10 | TPD-1 | 70 | 4.65 | Comparative |
| 11 | TPD-3 | 72 | 4.55 | Comparative |
| 12 | PTS | 80 | 4.88 | Comparative |
| 13 | Si-1 | 85 | 4.90 | Comparative |
| 14 | Si-2 | 90 | 4.86 | Comparative |
| 15 | TAA-Si1 | 60 | 4.70 | Comparative |

Ph-PA is the compound described in Advanced Functional Materiel, Vol. 18, p. 3966, 2008.

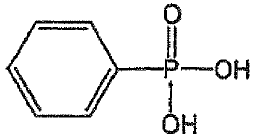

TPD-1 is the compound described in Advanced Functional Material, Vol. 18, p. 3966, 2008.

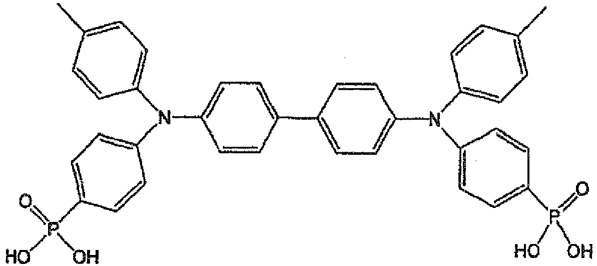

TPD-3 is the compound described in Advanced Functional Material, Vol. 18, p. 3966, 2008.

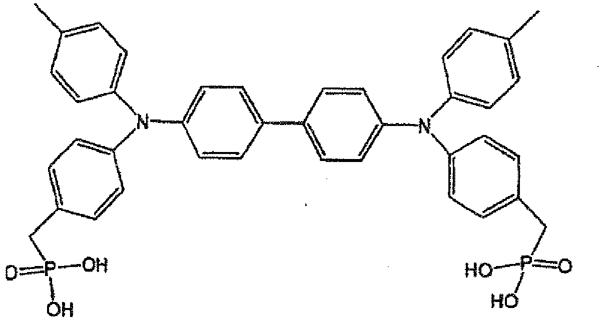

PTS is the compound described in Langmuir, Vol. 23, p. 13223,2007.

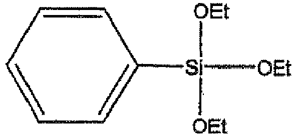

Si-1 is the compound described in Japanese Unexamined Patent Publication No. 2005-85731.

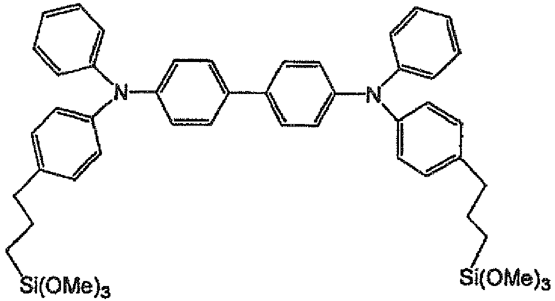

Si-2 is the compound described in Japanese Unexamined Patent Publication No. 2005-85731.

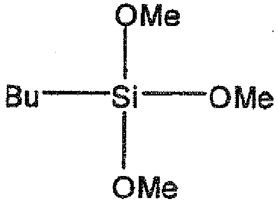

TAA-Si1 is the compound described in Accounts of Chemical Research, Vol. 38, p. 632, 2005.

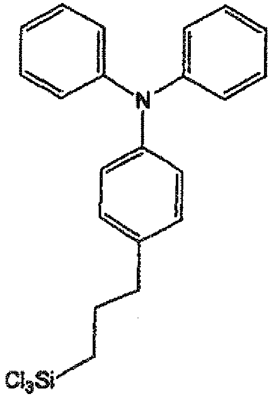

As can be shown from the results, the inorganic material substrates modified with the inventive compounds had contact angles ranging 80° to 92° and work functions ranging from 5.2 to 5.5. In contrast, some of the known compounds had contact angles of 80° to 92°, but their work functions were lower than 5.0. The contact angle range of 80° to 100° can contribute to improvements in adhesiveness and device durability when applied to devices because the hydrophilicity and hydrophobicity of the modified inorganic material substrates lie in the same level as those of organic semiconductor compounds generally used in organic devices.

The work function range of 5.2 to 5.5 can contribute to efficient injection of charges into organic semiconductor compounds from electrodes. That is, the inventive compounds, each of which is characterized by the presence of only one coupling moiety in the arylamine structure containing two or more nitrogen atoms, contribute to increases in the hydrophobicity and work function of the electrodes. In contrast, the conventional compounds, each of which has two coupling moieties in the arylamine structure containing two or more nitrogen atoms, are effective in increasing the hydrophobicity of the electrodes but their work functions are lower than the work function of the unmodified electrode, thus being unsuitable for use in organic devices.

The reason for this is believed to be because the presence of only one coupling moiety allows for uniform alignment and close packing of the arylamine moieties in a direction substantially perpendicular to the electrode substrate, whereas two coupling moieties allows the arylamine moieties to be sparsely present in a direction horizontal to the electrode substrate. The arylamine moieties in a uniformly aligned and closely packed state are thought to increase the performance of an organic device and particularly to effectively function to increase the efficiency and durability of an organic device.

### <Example 2>

### (Fabrication of organic EL devices)

Each of the substrates modified with the inventive compounds was used as an anode, and the following layers were formed thereon by vacuum deposition. In the examples, deposition rates are 0.2 nm/sec unless otherwise specified. The deposition rates were measured using a quartz oscillator. The film thicknesses were measured using a quartz oscillator.

### -Hole transport layer-

α-NPD was deposited on the substrate modified with the inventive compound. The film thickness was 20 nm.

### -Light-emitting layer-

Ir(ppy)₃ as a light-emitting material and CBP as a host material in a weight ratio of 32:68 were co-deposited to a thickness of 30 nm on the hole transport layer.

### -Electron transport layer-

BAlq was deposited to a film thickness of 39 nm on the light-emitting layer.

### -Cathode-

A patterned mask having a light-emitting area of 2 mm x 2 mm was disposed on the hole transport layer, lithium fluoride was deposited to a thickness of 0.5 nm on the hole transport layer therethrough, and aluminum was deposited to a thickness of 100 nm to form a cathode.

The resulting laminate was placed in a glove box introduced with argon gas, and sealed using a sealing can made of stainless steel and a UV curable adhesive (XNR5516HV, Nagase Chiba, Co., Ltd.).

### (Performance Evaluation)

### (1) Luminescence Efficiency

The luminance, emission spectrum and current density of the electroluminescence device were measured. A relative spectral luminous efficiency curve for the electroluminescence device was depicted. From the measurement results and the curve, the external quantum efficiency of the electroluminescence device was calculated by "(the number of photons emitted from the device/the number of electrons injected into the device) × 100".

### (2) Driving Voltage

The driving voltage (V) of the device was measured at an illuminance of 300 cd/m².

### (3) Driving durability

The device was continuously driven at an initial luminance of 300 cd/m². The driving durability (h) was defined as the time when the luminance decreased to half of its initial value.

### (Evaluation Results)

The obtained results are shown in Table 2.

**[TABLE 2]**

| Device No. | Compound No. | External quantum yield (%) | Driving voltage (V) | Driving durability (h) | Remark |
|---|---|---|---|---|---|
| 1 | 1 | 6.50 | 9.8 | 460 | Inventive |
| 2 | 3 | 7.20 | 9.5 | 480 | Inventive |
| 3 | 8 | 6.50 | 9.0 | 520 | Inventive |
| 4 | 12 | 8.10 | 9.5 | 430 | Inventive |
| 5 | 19 | 8.30 | 9.5 | 400 | Inventive |
| 6 | 23 | 8.50 | 8.6 | 460 | Inventive |
| 7 | 29 | 7.50 | 9.8 | 440 | Inventive |
| 8 | Unmodified | 2.00 | 12.0 | 360 | Comparative |
| 9 | Ph-PA | 2.20 | 12.5 | 360 | Comparative |
| 10 | TPD-1 | 2.05 | 12.0 | 350 | Comparative |
| 11 | TPD-3 | 2.40 | 11.4 | 380 | Comparative |
| 12 | PTS | 2.80 | 12.8 | 360 | Comparative |
| 13 | Si-1 | 2.50 | 11.3 | 330 | Comparative |
| 14 | Si-2 | 3.00 | 13.0 | 380 | Comparative |
| 15 | TAA-Si1 | 2.80 | 10.4 | 280 | Comparative |

As can be seen from the evaluation results, the organic EL devices using the inorganic material substrates modified with the inventive compounds had high external quantum yield, low driving voltage and high driving durability.

### <Example 3>

### (Fabrication of coating type organic EL devices)

A mixture of polyvinylcarbazole (number average molecular weight = 30,000, manufactured by Aldrich), CBP and Ir(PPy)₃ in a weight ratio of 32:63:5 was dissolved in dichloroethane. The solution was applied to each of the substrates modified with the inventive compounds as an anode by spin coating to form a film having a dry thickness of 50 nm as a light-emitting layer. The following layers were deposited on the light-emitting layer by vacuum deposition.

### -Electron transport layer-

BAlq was deposited to a film thickness of 39 nm on the light-emitting layer.

### -Cathode-

A patterned mask having a light-emitting area of 2 mm x 2 mm was disposed on the electron transport layer, lithium fluoride was deposited to a thickness of 0.5 nm on the electron transport layer therethrough, and aluminum was deposited to a thickness of 100 nm to form a cathode.

The resulting laminate was placed in a glove box introduced with argon gas, and sealed using a sealing can made of stainless steel and a UV curable adhesive (XNR5516HV, Nagase Chiba, Co., Ltd.).

### (Performance Evaluation)

The performance of the device was evaluated in the same manner as in Example 2. The results are shown in Table 3.

**[TABLE 3]**

| Device No. | Compound No. | External quantum yield (%) | Driving voltage (V) | Driving durability (h) | Remark |
|---|---|---|---|---|---|
| 16 | 1 | 4.90 | 9.80 | 420 | Inventive |
| 17 | 3 | 4.80 | 10.2 | 370 | Inventive |
| 18 | 8 | 5.40 | 9.5 | 410 | Inventive |
| 19 | 12 | 6.70 | 9.6 | 360 | Inventive |
| 20 | 19 | 7.80 | 10.0 | 390 | Inventive |
| 21 | 23 | 7.60 | 9.2 | 340 | Inventive |
| 22 | 29 | 6.20 | 10.8 | 400 | Inventive |
| 23 | Unmodified | 1.20 | 14.0 | 280 | Comparative |
| 24 | Ph-PA | 1.20 | 12.5 | 300 | Comparative |
| 25 | TPD-1 | 1.10 | 14.5 | 270 | Comparative |
| 26 | TPD-3 | 1.40 | 13.0 | 310 | Comparative |
| 27 | PTS | 1.60 | 13.8 | 290 | Comparative |
| 28 | Si-1 | 1.40 | 11.7 | 270 | Comparative |
| 29 | Si-2 | 1.80 | 11.0 | 290 | Comparative |
| 30 | TAA-Si1 | 2.00 | 11.6 | 200 | Comparative |

As can be seen from the evaluation results, the organic EL devices using the inorganic material substrates modified with the inventive compounds had high external quantum yield, low driving voltage and high driving durability.

The structures of the compounds used in the examples are shown below.

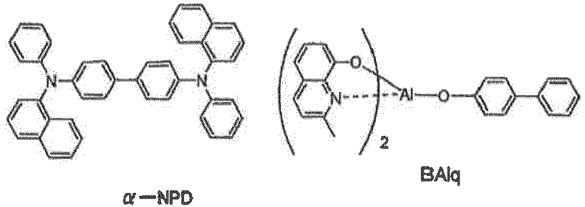

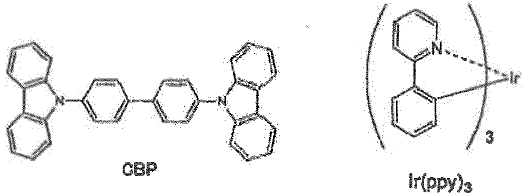

### INDUSTRIAL APPLICABILITY

The organic electroluminescence device of the present invention is highly efficient and long-life. In addition, the electrode of the present invention is used in the organic electroluminescence device.

This application is based on Japanese Patent Application No. 2009-077626 filed on March 26, 2009.

### EXPLANATION OF REFERENCE NUMERALS

| | |
|---|---|
| 1: Substrate | 2: Transparent electrode |
| 3: Organic compound layer | 4: Back electrode |
| 5: Transparent electrode lead | 6: Back electrode lead |
| 7: Light-emitting laminate | 8: Sealant (adhesive) |
| 9: Sealing member | 10: Space |

## Claims

1. An electrode consisting of an inorganic material modified with a compound,
wherein the compound is selected from Compounds 1 to 16 according to Formula (b) 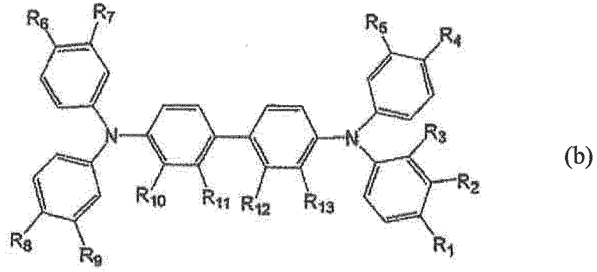
| No. | Adsorbing moiety | Other substituents |
|---|---|---|
| 1 | R1 = (CH₂)₄Si(OEt)₃ | R2-R13 = H |
| 2 | R2 = O(CH₂)₄PO(OH)₂ | R1, R3-R13 = H |
| 3 | R1 = O(CH₂)₃PC)(OH)₂ | R7 = Me, R2-R6, R8-R13 = H |
| 4 | R2 = (CH₂)₄PO(OH)₂ | R7, R9 = Me, R1, R3-R6, R8, R10-R13 = H |
| 5 | R1 = OCO(CH₂)₅PO(OH)₂ | R2-R13 = H |
| 6 | R3 = CO(CH₂)₄PO(OH)₂ | R7, R10 = Me, R1, R2, R4-R6, R8, R9, R11-R13 = H |
| 7 | R1 = O(CH₂)₃PO(OH)₂ | R7 = OMe, R2-R6, R8-R13 = H |
| 8 | R1 = O(CH₂)₅Si(OEt)₃ | R7 = Me, R2-R6, R8-R13 = H |
| 9 | R1 = (CH₂)₄PO(OH)₂ | R7 = Ph, R2-R6, R8-R13 = H |
| 10 | R1 = O(CH₂)₂O(CH₂)₂PO(OH)₂ | R7 = F, R2-R6, R8-R13 = H |
| 11 | R1 = PO(OH)₂ | R2-R13 = H |
| 12 | R1 = PO(OH)₂ | R4, R6 = Me, R2, R3, R5, R7-R13 = H |
| 13 | R2 = O(CH₂)₄Si(OMe)₃ | R5 = Me, R1, R3-R4, R6-R13 = H |
| 14 | R2 = OCONH(CH₂)₄Si(OMe)₃ | R5, R7, R9 = Me, R1, R3, R4, R6, R8, R10-R13 = H |
| 15 | R3 = (CH=CH)PO(OH)₂ | R10, R13 = Me, R1, R2, R4-R9, R11, R12 = H |
| 16 | R1 = NHCO(CH₂)₅PO(OH)₂ | R11, R12 = Me, R2-R10, R13 =H |
or
wherein the compound is selected from Compounds 17 to 32 according to Formula (c) 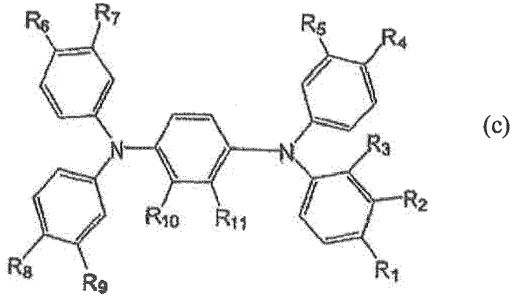
| No. | Adsorbing moiety | Other substituents |
|---|---|---|
| 17 | R1 = O(CH₂)₅PO(OH)₂ | R2-R11 = H |
| 18 | R2 = O(CH₂)₄PO(OH)₂ | R1, R3-R11 = H |
| 19 | R1 = O(CH₂)₃PO(OH)₂ | R3 = Me, R2, R4-R11 = H |
| 20 | R2 = (CH₂)₄PO(OH)₂ | R7, R9 = Me, R1, R3-R6, R8, R10, R11 = H |
| 21 | R1 = OCO(CH₂)₅PO(OH)₂ | R2-R11 = H |
| 22 | R3 = CO(CH₂)₄PO(OH)₂ | R7, R10 = Me, R1, R2, R4-R6, R8, R9, R11 = H |
| 23 | R1 = O(CH₂)₃PO(OH)₂ | R7 = OMe, R2-R6, R8-R11 = H |
| 24 | R1 = O(CH₂)₅PO(OH)₂ | R7 = Et, R2-R6, R8-R11 =H |
| 25 | R1 = (CH₂)₄Si(OMe)₃ | R7 = Ph, R2-R6, R8-R11 = H |
| 26 | R1 = O(CH₂)₂O(CH₂)₂PO(OH)₂ | R7 = F, R2-R6, R8-R11 = H |
| 27 | R1=PO(OH)₂ | R2-R11=H |
| 28 | R1 = Si(OMe)₃ | R7, R8 = Ph, R2-R6, R8, R10, R11 = H |
| 29 | R2 = O(CH₂)₄Si(OEt)₃ | R5 = Me, R1, R3-R4, R6-R11 = H |
| 30 | R2 = OCONH(CH₂)₃PO(OH)₂ | R5, R7, R9 = Me, R1, R3, R4, R6, R8, R10, R11 = H |
| 31 | R3 = (CH=CH)Si(OMe)₃ | R10 = Me, R1, R2, R4-R9, R11 = H |
| 32 | R1 = NHCO(CH₂)₅PO(OH)₂ | R11 = Me, R2-R10 =H |
or
wherein the compound is selected from Compounds 33 to 43 according to Formula (d) 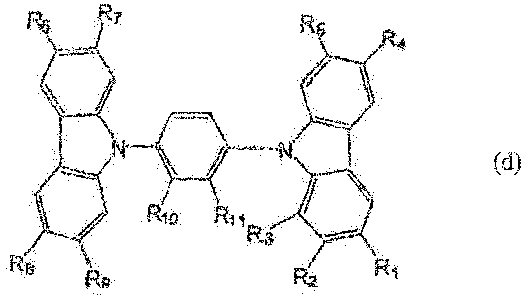
| No. | Adsorbing moiety | Other substituents |
|---|---|---|
| 33 | R1 = O(CH₂)₅PO(OH)₂ | R2-R11 = H |
| 34 | R2 = O(CH₂)₄PO(OH)₂ | R1, R3-R11 = H |
| 35 | R1 = O(CH₂)₃PO(OH)₂ | R7 = Me, R2-R6, R8-R11 = H |
| 36 | R2 = (CH₂)₄PO(OH)₂ | R7, R9 = Me, R1, R3-R6, R8, R10, R11 = H |
| 37 | R1 = OCO(CH₂)₄Si(OMe)₃ | R2-R11 = H |
| 38 | R3 = CO(CH₂)₄PO(OH)₂ | R7, R10 = Me, R1, R2, R4-R6, R8, R9, R11 = H |
| 39 | R1 = O(CH₂)₃PO(OH)₂ | R7 = OMe, R2-R6, R8-R11 = H |
| 40 | R1 = O(CH₂)₄Si(OMe)₃ | R7 = Et, R2-R6, R8-R11 = H |
| 41 | R1 = (CH₂)₄PO(OH)₂ | R7 = Ph, R2-R6, R8-R11 = H |
| 42 | R1 = SiO(Me)₃ | R7 = F, R2-R6, R8-R11 = H |
| 43 | R1 = PO(OH)₂ | R2-R11 = H |
or
wherein the compound is selected from Compounds 44 to 51 according to Formula (e) 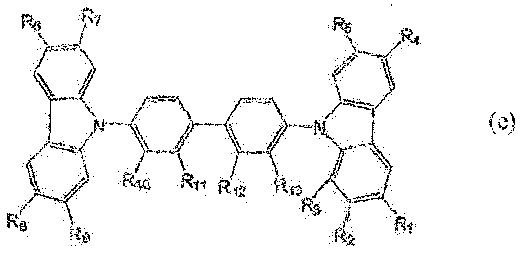
| No. | Adsorbing moiety | Other substituents |
|---|---|---|
| 44 | R1 = O(CH₂)₅PO(OH)₂ | R2-R13 = H |
| 45 | R2 = O(CH₂)₄PO(OH)₂ | R1, R3-R13 = H |
| 46 | R1 = O(CH₂)₃PO(OH)₂ | R7 = Me, R2-R6, R8-R13 = H |
| 47 | R2 = (CH₂)₄PO(OH), | R7, R9 = Me, R1, R3-R6, R8, R10-R13 = H |
| 48 | R1 = OCO(CH₂)₅PO(OH)₂ | R2-R13 = H |
| 49 | R3 = CO(CH₂)₄PO(OH)₂ | R7, R10, R13= Me, R1, R2, R4-R6, R8, R9, R11, R12=H |
| 50 | R1 = O(CH₂)₄SiCl₃ | R7 = OMe, R2-R6, R8-R13 = H |
| 51 | R1 = PO(OH)₂ | R2-R13 = H |

2. An electrode according to claim 1, wherein the inorganic material is a metal oxide.

3. An electrode according to any preceding claim, wherein the inorganic material is a transparent electrode (2).

4. An electrode according to any preceding claim, wherein the inorganic material is indium tin oxide (ITO).

5. An organic electroluminescence device comprising an electrode as defined in any preceding claim.

6. An organic electroluminescence device according to claim 5, wherein the electrode is an anode.

## Patentansprüche

1. Eine Elektrode, die aus einem anorganischen Material besteht, das mit einer Verbindung modifiziert ist,
wobei die Verbindung ausgewählt ist aus den Verbindungen 1 bis 16 gemäß Formel (b) 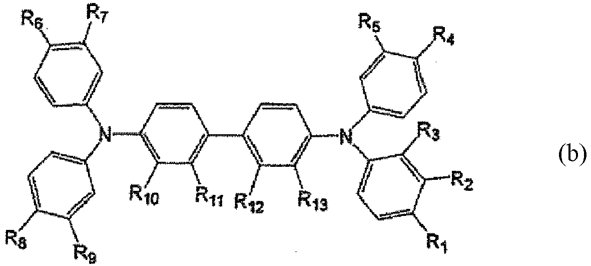
| Nr. | Adsorptionsgruppe | andere Substituenten |
|---|---|---|
| 1 | R1 =(CH₂)₄Si(OEt)₃ | R2-R13 = H |
| 2 | R2 = O(CH₂)₄PO(OH)₂ | R1, R3-R13 = H |
| 3 | R1 = O(CH₂)₃PO(OH)₂ | R7 = Me, R2-R6, R8-R13 = H |
| 4 | R2 = (CH₂)₄PO(OH)₂ | R7, R9 = Me, R1, R3-R6, R8, R10-R13 = H |
| 5 | R1 = OCO(CH₂)₅PO(OH)₂ | R2-R13 = H |
| 6 | R3 = CO(CH₂)₄PO(OH)₂ | R7, R10 = Me, R1, R2, R4-R6, R8, R9, R11-R13 = H |
| 7 | R1 = O(CH₂)₃PO(OH)₂ | R7 = OMe, R2-R6, R8-R13 = H |
| 8 | R1 = O(CH₂)₅Si(OEt)₃ | R7 = Me, R2-R6, R8-R13 = H |
| 9 | R1 = (CH₂)₄PO(OH)₂ | R7 = Ph, R2-R6, R8-R13 = H |
| 10 | R1 = O(CH₂)₂O(CH₂)₂PO(OH)₂ | R7 = F, R2-R6, R8-R13 = H |
| 11 | R1 = PO(OH)₂ | R2-R13 = H |
| 12 | R1 = PO(OH)₂ | R4, R6 = Me, R2, R3, R5, R7-R13 = H |
| 13 | R2 = O(CH₂)₄Si(OMe)₃ | R5 = Me, R1, R3-R4, R6-R13 = H |
| 14 | R2 = OCONH(CH₂)₄Si(OMe)₃ | R5, R7, R9 = Me, R1, R3, R4, R6, R8, R10-R13 = H |
| 15 | R3 = (CH=CH)PO(OH)₂ | R10, R13 = Me, R1, R2, R4-R9, R11, R12 = H |
| 16 | R1 = NHCO(CH₂)₅PO(OH)₂ | R11, R12 = Me, R2-R10, R13 =H |
oder
wobei die Verbindung ausgewählt ist aus den Verbindungen 17 to 32 gemäß Formel (c) 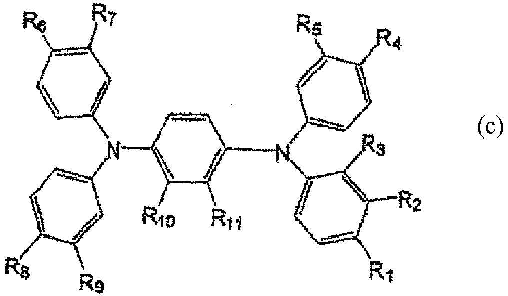
| Nr. | Adsorptionsgruppe | andere Substituenten |
|---|---|---|
| 17 | R1 = O(CH₂)₅PO(OH)₂ | R2-R11 = H |
| 18 | R2 = O(CH₂)₄PO(OH)₂ | R1, R3-R11 = H |
| 19 | R1 = O(CH₂)₃PO(OH)₂ | R3 = Me, R2, R4-R11 = H |
| 20 | R2 = (CH₂)₄PO(OH)₂ | R7, R9 = Me, R1, R3-R6, R8, R10, R11 = H |
| 21 | R1 = OCO(CH₂)₅PO(OH)₂ | R2-R11 = H |
| 22 | R3 = CO(CH₂)₄PO(OH)₂ | R7, R10 = Me, R1, R2, R4-R6, R8, R9, R11 = H |
| 23 | R1 = O(CH₂)₃PO(OH)₂ | R7 = OMe, R2-R6, R8-R11 = H |
| 24 | R1 = O(CH₂)₅PO(OH)₂ | R7 = Et, R2-R6, R8-R11 =H |
| 25 | R1 = (CH₂)₄Si(OMe)₃ | R7 = Ph, R2-R6, R8-R11 = H |
| 26 | R1 = O(CH₂)₂O(CH₂)₂PO(OH)₂ | R7 = F, R2-R6, R8-R11 = H |
| 27 | R1=PO(OH)₂ | R2-R11=H |
| 28 | R1 = Si(OMe)₃ | R7, R8 = Ph, R2-R6, R8, R10, R11 = H |
| 29 | R2 = O(CH₂)₄Si(OEt)₃ | R5 = Me, R1, R3-R4, R6-R11 = H |
| 30 | R2 = OCONH(CH₂)₃PO(OH)₂ | R5, R7, R9=Me, R1, R3, R4, R6, R8, R10, R11 =H |
| 31 | R3 = (CH=CH)Si(OMe)₃ | R10 = Me, R1, R2, R4-R9, R11 = H |
| 32 | R1 = NHCO(CH₂)₅PO(OH)₂ | R11 = Me, R2-R10 =H |
oder
wobei die Verbindung ausgewählt ist aus den Verbindungen 33 to 43 gemäß Formel (d) 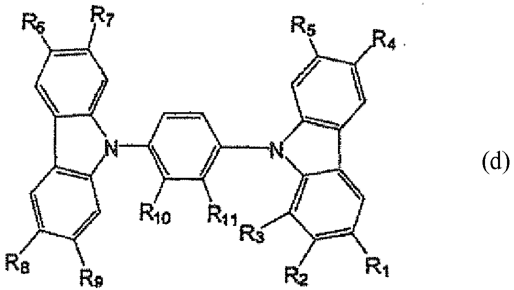
| Nr. | Adsorptionsgruppe | andere Substituenten |
|---|---|---|
| 33 | R1 = O(CH₂)₅PO(OH)₂ | R2-R11 = H |
| 34 | R2 = O(CH₂)₄PO(OH)₂ | R1, R3-R11 = H |
| 35 | R1 = O(CH₂)₃PO(OH)₂ | R7 = Me, R2-R6, R8-R11 = H |
| 36 | R2 = (CH₂)₄PO(OH)₂ | R7, R9 = Me, R1, R3-R6, R8, R10, R11 = H |
| 37 | R1 = OCO(CH₂)₄Si(OMe)₃ | R2-R11 = H |
| 38 | R3 = CO(CH₂)₄PO(OH)₂ | R7, R10 = Me, R1, R2, R4-R6, R8, R9, R11 = H |
| 39 | R1 = O(CH₂)₃PO(OH)₂ | R7 = OMe, R2-R6, R8-R11 = H |
| 40 | R1 = O(CH₂)₄Si(OMe)₃ | R7 = Et, R2-R6, R8-R11 = H |
| 41 | R1 = (CH₂)₄PO(OH)₂ | R7 = Ph, R2-R6, R8-R11 = H |
| 42 | R1 = SiO(Me)₃ | R7 = F, R2-R6, R8-R11 = H |
| 43 | R1 = PO(OH)₂ | R2-R11 = H |
oder
wobei die Verbindung ausgewählt ist aus den Verbindungen 44 to 51 gemäß Formel (e) 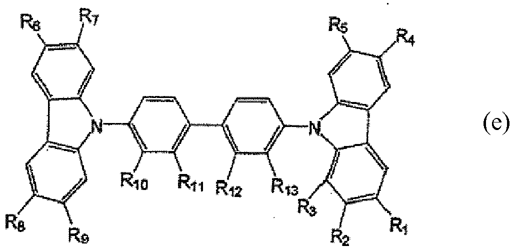
| Nr. | Adsorptionsgruppe | andere Substituenten |
|---|---|---|
| 44 | R1 = O(CH₂)₅PO(OH)₂ | R2-R13 = H |
| 45 | R2 = O(CH₂)₄PO(OH)₂ | R1, R3-R13 = H |
| 46 | R1 = O(CH₂)₃PO(OH)₂ | R7 = Me, R2-R6, R8-R13 = H |
| 47 | R2 = (CH₂)₄PO(OH), | R7, R9 = Me, R1, R3-R6, R8, R10-R13 = H |
| 48 | R1 = OCO(CH₂)₅PO(OH)₂ | R2-R13 = H |
| 49 | R3 = CO(CH₂)₄PO(OH)₂ | R7, R10, R13 = Me, R1, R2, R4-R6, R8, R9, R11, R12 = H |
| 50 | R1 = O(CH₂)₄SiCl₃ | R7 = OMe, R2-R6, R8-R13 = H |
| 51 | R1 = PO(OH)₂ | R2-R13 = H |

2. Eine Elektrode nach Anspruch 1, wobei das anorganische Material ein Metalloxid ist.

3. Eine Elektrode nach einem der vorhergehenden Ansprüche, wobei das anorganische Material eine transparente Elektrode (2) ist.

4. Eine Elektrode nach einem der vorhergehenden Ansprüche, wobei das anorganische Material Indiumzinnoxid (ITO) ist.

5. Eine organische Elektrolumineszenzvorrichtung umfassend eine Elektrode nach einem der vorhergehenden Ansprüche.

6. Eine organische Elektrolumineszenzvorrichtung nach Anspruch 5, wobei die Elektrode eine Anode ist.

## Revendications

1. Électrode constituée d'une matière inorganique modifiée par un composé, le composé étant choisi parmi les Composés 1 à 16 selon la Formule (b) 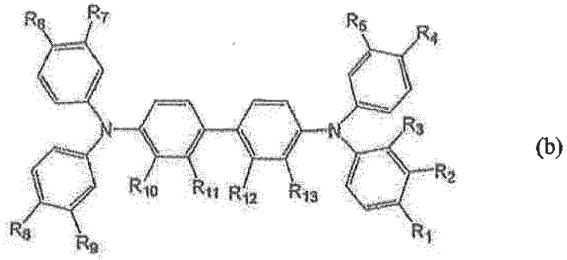
| N° | Groupement adsorbant | Autres substituants |
|---|---|---|
| 1 | R1 = (CH₂)₄Si(OEt)₃ | R2-R13 = H |
| 2 | R2 = O(CH₂)₄PO(OH)₂ | R1, R3-R13 = H |
| 3 | R1 = O(CH₂)₃PO(OH)₂ | R7 = Me, R2-R6, R8-R13 = H |
| 4 | R2 = (CH₂)₄PO(OH)₂ | R7, R9 = Me, R1, R3-R6, R8, R10-R13 = H |
| 5 | R1 = OCO(CH₂)₅PO(OH)₂ | R2-R13 = H |
| 6 | R3 = CO(CH₂)₄PO(OH)₂ | R7, R10 = Me, R1, R2, R4-R6, R8, R9, R11-R13 = H |
| 7 | R1 = O(CH₂)₃PO(OH)₂ | R7 = OMe, R2-R6, R8-R13 = H |
| 8 | R1 = O(CH₂)₅Si(OEt)₃ | R7 = Me, R2-R6, R8-R13 = H |
| 9 | R1 = (CH₂)₄PO(OH)₂ | R7 = Ph, R2-R6, R8-R13 = H |
| 10 | R1 = O(CH₂)₂O(CH₂)₂PO(OH)₂ | R7 = F, R2-R6, R8-R13 = H |
| 11 | R1 = PO(OH)₂ | R2-R13 = H |
| 12 | R1 = PO(OH)₂ | R4, R6 = Me, R2, R3, R5, R7-R13 = H |
| 13 | R2 = O(CH₂)₄Si(OMe)₃ | R5 = Me, R1, R3-R4, R6-R13 = H |
| 14 | R2 = OCONH(CH₂)₄Si(OMe)₃ | R5, R7, R9 = Me, R1, R3, R4, R6, R8, R10-R13 = H |
| 15 | R3 = (CH=CH)PO(OH)₂ | R10, R13 = Me, R1, R2, R4-R9, R11, R12 = H |
| 16 | R1 = NHCO(CH₂)₅PO(OH)₂ | R1 1, R12 = Me, R2-R10, R13 = H |
ou
le composé étant choisi parmi les Composés 17 à 32 selon la Formule (c) 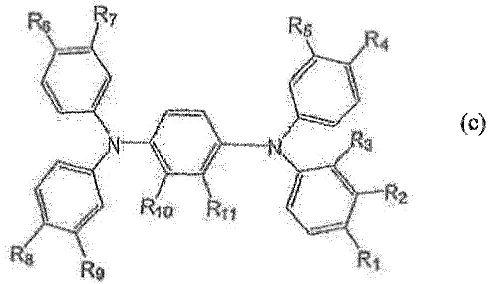
| N° | Groupement adsorbant | Autres substituants |
|---|---|---|
| 17 | R1 = O(CH₂)₅PO(OH)₂ | R2-R11 = H |
| 18 | R2 = O(CH₂)₄PO(OH)₂ | R1, R3-R11 = H |
| 19 | R1 = O(CH₂)₃PO(OH)₂ | R3 = Me, R2, R4-R11 = H |
| 20 | R2 = (CH₂)₄PO(OH)₂ | R7, R9 = Me, R1, R3-R6, R8, R10, R11 = H |
| 21 | R1 = OCO(CH₂)₅PO(OH)₂ | R2-R11 = H |
| 22 | R3 = CO(CH₂)₄PO(OH)₂ | R7, R10 = Me, R1, R2, R4-R6, R8, R9, R11 = H |
| 23 | R1 = O(CH₂)₃PO(OH)₂ | R7 = OMe, R2-R6, R8-R11 = H |
| 24 | R1 = O(CH₂)₅PO(OH)₂ | R7 = Et, R2-R6, R8-R11 =H |
| 25 | R1 = (CH₂)₄Si(OMe)₃ | R7 = Ph, R2-R6, R8-R11 = H |
| 26 | R1 = O(CH₂)₂O(CH₂)₂PO(OH)₂ | R7 = F, R2-R6, R8-R11 = H |
| 27 | R1=PO(OH)₂ | R2-R11 = H |
| 28 | R1 = Si(OMe)₃ | R7, R8 = Ph, R2-R6, R8, R10, R11 = H |
| 29 | R2 = O(CH₂)₄Si(OEt)₃ | R5 = Me, R1, R3-R4, R6-R11 = H |
| 30 | R2 = OCONH(CH₂)₃PO(OH)₂ | R5, R7, R9=Me, R1, R3, R4, R6, R8, R10, R11 = H |
| 31 | R3 = (CH=CH)Si(OMe)₃ | R10 = Me, R1, R2, R4-R9, R11 = H |
| 32 | R1 = NHCO(CH₂)₅PO(OH)₂ | R11 = Me, R2-R10 =H |
ou
le composé étant choisi parmi les Composés 33 à 43 selon la Formule (d) 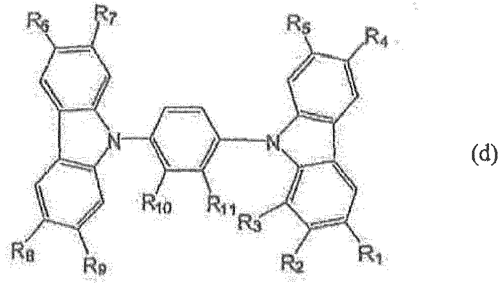
| N° | Groupement adsorbant | Autres substituants |
|---|---|---|
| 33 | R1 = O(CH₂)₅PO(OH)₂ | R2-R11 = H |
| 34 | R2 = O(CH₂)₄PO(OH)₂ | R1, R3-R11 = H |
| 35 | R1 = O(CH₂)₃PO(OH)₂ | R7 = Me, R2-R6, R8-R11 = H |
| 36 | R2 = (CH₂)₄PO(OH)₂ | R7, R9 = Me, R1, R3-R6, R8, R10, R11 = H |
| 37 | R1 = OCO(CH₂)₄Si(OMe)₃ | R2-R11 = H |
| 38 | R3 = CO(CH₂)₄PO(OH)₂ | R7, R10 = Me, R1, R2, R4-R6, R8, R9, R11 = H |
| 39 | R1 = O(CH₂)₃PO(OH)₂ | R7 = OMe, R2-R6, R8-R11 = H |
| 40 | R1 = O(CH₂)₄Si(OMe)₃ | R7 = Et, R2-R6, R8-R11 = H |
| 41 | R1 = (CH₂)₄PO(OH)₂ | R7 = Ph, R2-R6, R8-R11 = H |
| 42 | R1 = SiO(Me)₃ | R7 = F, R2-R6, R8-R11 = H |
| 43 | R1 = PO(OH)₂ | R2-R11 = H |
ou
le composé étant choisi parmi les Composés 44 à 51 selon la Formule (e) 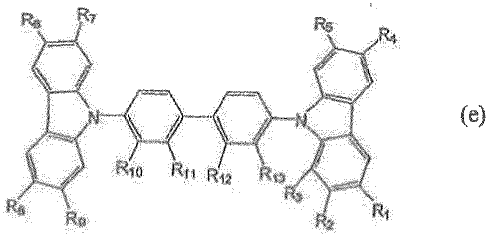
| N° | Groupement adsorbant | Autres substituants |
|---|---|---|
| 44 | R1 = O(CH₂)₅PO(OH)₂ | R2-R13 = H |
| 45 | R2 = O(CH₂)₄PO(OH)₂ | R1, R3-R13 = H |
| 46 | R1 = O(CH₂)₃PO(OH)₂ | R7 = Me, R2-R6, R8-R13 = H |
| 47 | R2 = (CH₂)₄PO(OH), | R7, R9 = Me, R1, R3-R6, R8, R10-R13 = H |
| 48 | R1 = OCO(CH₂)₅PO(OH)₂ | R2-R13 = H |
| 49 | R3 = CO(CH₂)₄PO(OH)₂ | R7, R10, R13 = Me, R1, R2, R4-R6, R8, R9, R11, R12 = H |
| 50 | R1 = O(CH₂)₄SiCl₃ | R7 = OMe, R2-R6, R8-R13 = H |
| 51 | R1 = PO(OH)₂ | R2-R13 = H |

2. Électrode selon la revendication 1, dans laquelle la matière inorganique est un oxyde métallique.

3. Électrode selon une quelconque revendication précédente, dans laquelle la matière inorganique est une électrode transparente (2).

4. Électrode selon une quelconque revendication précédente, dans laquelle la matière inorganique est l'oxyde d'indium et d'étain (ITO).

5. Dispositif à électroluminescence organique comprenant une électrode telle que définie dans une quelconque revendication précédente.

6. Dispositif à électroluminescence organique selon la revendication 5, dans lequel l'électrode est une anode.
